# EUROPEAN PATENT SPECIFICATION

(11) **EP 3 715 501 B1**
(45) Date of publication and mention of the grant of the patent: **27.11.2024**
(21) Application number: 20165340.9
(22) Date of filing: 24.03.2020
(51) Int. Cl.: C23C 16/455, C30B 25/14, H01L 21/67, H01L 21/673, H01L 21/677

(54) **REACTION TUBE, SUBSTRATE PROCESSING APPARATUS AND METHOD OF MANUFACTURING SEMICONDUCTOR DEVICE**
REAKTIONSROHR, SUBSTRATVERARBEITUNGSVORRICHTUNG UND VERFAHREN ZUR HERSTELLUNG EINES HALBLEITERBAUELEMENTS
TUBE DE RÉACTION, APPAREIL DE TRAITEMENT DE SUBSTRAT ET PROCÉDÉ DE FABRICATION DE DISPOSITIF SEMICONDUCTEUR

(30) Priority: 26.03.2019 JP 2019059430; 20.02.2020 JP 2020027459
(43) Date of publication of application: 30.09.2020
(73) Proprietor: Kokusai Electric Corp., Tokyo 1010045 (JP)
(72) Inventor: MARUBAYASHI, Tetsuya, Toyama-shi, Toyama 939-2393 (JP); MURATA, Satoru, Toyama-shi, Toyama 939-2393 (JP); HIRANO, Atsushi, Toyama-shi, Toyama 939-2393 (JP); NAKAMURA, Iwao, Toyama-shi, Toyama 939-2393 (JP)
(74) Representative: Verscht, Thomas Kurt Albert

(56) References cited:
- JP-A- 2012 248 675
- JP-A- S61 114 522
- US-A- 5 458 685
- US-A- 5 948 300

## Description

### [Technical Field]

The present disclosure relates to a reaction tube, a substrate processing apparatus and a method of manufacturing a semiconductor device.

### [Related Art]

The present disclosure relates to a reaction tube, a substrate processing apparatus and a method of manufacturing a semiconductor device.

### [Related Art]

A substrate processing apparatus may be configured to perform a process such as an oxidation process and a diffusion process. According to the substrate processing apparatus, for example, a gas such as a process gas is introduced through a gas introduction port provided at a bottom of a reaction tube of the substrate processing apparatus, and then is supplied into a reaction chamber (also referred to as a "process chamber"). According to Patent Document 1 and Patent Document 2 described below, a space where the gas is temporarily stored to adjust a pressure of the gas is provided at the reaction tube, and the gas is supplied into the reaction chamber through the space.

According to Patent Document 3 described below, a preheating cylinder is provided below a substrate processing region of a substrate retainer and a gas introduction portion of the substrate processing apparatus, and the gas introduced through the gas introduction portion flows upward via the preheating cylinder.

According to Patent Document 4 described below, the gas supplied through a pipe disposed below the substrate processing region of the substrate retainer is preheated.

However, the gas introduced through the gas introduction portion may pass through the pipe arranged on a side surface of the substrate processing region without sufficiently heated to a desired temperature. As a result, a temperature of an outer periphery of a lower portion of the substrate processing region may decrease, and thus processing results between substrates accommodated in the substrate processing region may vary.

### [Patent Documents]

[Patent Document 1] Japanese Patent Application Laid-Open No. H11-067750
[Patent Document 2] Japanese Patent Application Laid-Open No. 2018-088520
[Patent Document 3] Japanese Patent Application Laid-Open No. 2012-248675
[Patent Document 4] U.S. Patent No. 5,948,300

### [Disclosure]

### [Technical Problem]

Described herein is a technique capable of reducing a difference in processing results between substrates arranged in a substrate processing region.

### [Technical Solution]

According to one aspect of the technique of the present disclosure, there is provided a reaction tube provided therein with a process chamber and heated by a heater provided therearound including: a gas introduction portion provided at a lower end and through which a process gas is introduced; a first supplier provided along a side surface at least at a position facing a substrate processing region where a plurality of substrates are processed; and a preheating portion provided at a position lower than the substrate processing region, the preheating portion including: a first preheating portion extending in a direction from the gas introduction portion toward a ceiling; and a second preheating portion extending in a direction perpendicular to the direction from the gas introduction portion toward the ceiling, wherein the preheating portion is configured to connect the gas introduction portion with the first supplier by combining the first preheating portion and the second preheating portion, and wherein a cross-sectional shape of the first preheating portion is different from that of the second preheating portion.

Preferred embodiments of the invention are disclosed in the dependent claims.

### [Advantageous Effects]

According to some embodiments in the present disclosure, it is possible to suppress the decrease in the temperature of the substrate processing region due to the flow of the gas, and as a result, it is possible to reduce the difference in the processing results between substrates arranged in the substrate processing region.

### [Brief Description of Drawings]

FIG. 1 schematically illustrates a vertical cross-section of a substrate processing apparatus according to a first embodiment described herein.
FIG. 2 is a block diagram schematically illustrating a controller of the substrate processing apparatus according to the first embodiment described herein.
FIG. 3 schematically illustrates a vertical cross-section of a process furnace of the substrate processing apparatus according to the first embodiment described herein.
FIGS. 4A through 4C schematically illustrate a reaction tube of the substrate processing apparatus according to the first embodiment described herein, and FIG. 4D schematically illustrates a vertical cross-section of a preheating portion of the substrate processing apparatus according to the first embodiment described herein.
FIG. 5 schematically illustrates a horizontal cross-section of the process furnace of the substrate processing apparatus according to the first embodiment described herein.
FIG. 6 schematically illustrates an internal structure of the process furnace of the substrate processing apparatus according to the first embodiment described herein.
FIG. 7 schematically illustrates an internal structure of a process furnace of a substrate processing apparatus according to a second embodiment described herein.
FIGS. 8A and 8B schematically illustrate a reaction tube of the substrate processing apparatus according to a third embodiment described herein, and FIG. 8C schematically illustrates a vertical cross-section of a preheating portion of the substrate processing apparatus according to the third embodiment described herein.
FIG. 9 schematically illustrates a vertical cross-section of a process furnace of a substrate processing apparatus according to a first comparative example described herein.
FIG. 10 schematically illustrates configurations of the reaction tubes of the substrate processing apparatuses according to comparative examples and examples used in test examples.
FIG. 11 schematically illustrates test results showing temperature distributions of the reaction tubes of the substrate processing apparatuses according to the comparative examples and the examples.
FIG. 12 schematically illustrates temperatures of inner walls of the reaction tubes of the substrate processing apparatuses according to the comparative examples and the examples.
FIG. 13 schematically illustrates a reaction tube and a preheating portion of a substrate processing apparatus according to another embodiment described herein.
FIG. 14 schematically illustrates a reaction tube and a preheating portion of a substrate processing apparatus according to still another embodiment described herein.

### [Detailed Description]

Hereinafter, embodiments according to the technique of the present disclosure will be described with reference to the drawings.

### <First Embodiment>

A substrate processing apparatus (also simply referred to as a "processing apparatus") 100 according to embodiments of the present disclosure is configured to process a semiconductor wafer. Specifically, for example, the substrate processing apparatus 100 is configured to perform a substrate processing such as a film-forming process of forming an oxide film on the semiconductor wafer, a diffusion process on the semiconductor wafer and a CVD process on the semiconductor wafer. According to the embodiments described herein, the semiconductor wafer (hereinafter, also simply referred to as a "wafer") 200 serving as a substrate is made of a semiconductor material such as silicon (Si). According to the first embodiment, a FOUP (front opening unified pod) 110 is used as a carrier (container) of accommodating and transporting (transferring) a plurality of wafers including the wafer 200.

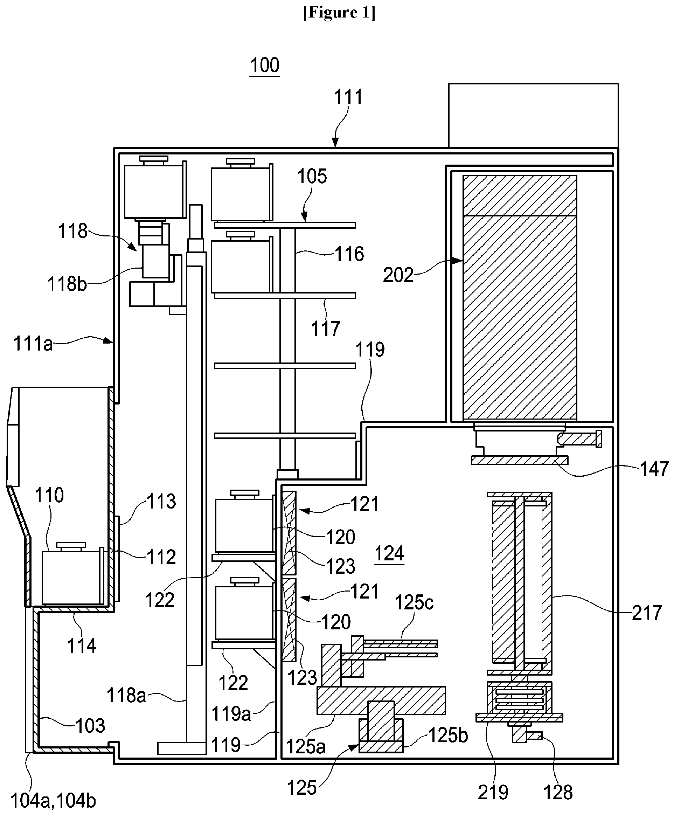

As shown in FIG. 1, the processing apparatus 100 according to the first embodiment includes a housing 111. A maintenance space is provided at a lower front portion of a front wall 111a of the housing 111. Front maintenance doors 104a and 104b configured to open and close the maintenance space are provided at the lower front portion of the front wall 111a of the housing 111.

A pod loading/unloading port 112 is provided at the front wall 111a of the housing 111 so as to communicate with an inside and an outside of the housing 111. The FOUP (hereinafter, also referred to as a "pod") 110 may be transferred (loaded) into and transferred (unloaded) out of the housing 111 through the pod loading/unloading port 112. A front shutter 113 is configured to open and close the pod loading/unloading port 112.

A loading port (also referred to as a "load port shelf) 114 is provided in front of the pod loading/unloading port 112. The pod 110 is aligned while placed on the load port shelf 114. The pod 110 is loaded onto or unloaded from the load port shelf 114 by an in-process transfer apparatus (not shown).

An accommodating shelf 105 is provided over a substantially center portion in a front-rear direction in the housing 111. The accommodating shelf 105 is configured to hold (store) the pod 110 and is rotatable. The accommodating shelf 105 may hold a plurality of pods (also simply referred to as "pods") including the pod 110. That is, the accommodating shelf 105 includes a vertical column 116 and a plurality of shelf plates (also simply referred to as "shelf plates") 117 provided at the vertical column 116. Each of the shelf plates 117 is configured to support pods such as the pod 110 placed thereon.

A pod transport device 118 serving as a first transport device is provided between the load port shelf 114 and the accommodating shelf 105 in the housing 111. The pod 110 may be elevated or lowered by the pod transport device 118 while supported by the pod transport device 118. The pod transport device 118 may include a pod elevator 118a and a pod transport mechanism 118b. The pod transport device 118 is configured to transport the pod 110 among the load port shelf 114, the accommodating shelf 105 and a pod opener 121 described later by consecutive operations of the pod elevator 118a and the pod transport mechanism 118b.

The substrate processing apparatus 100 includes a semiconductor manufacturing apparatus that performs the substrate processing such as the film-forming process of forming the oxide film. A sub-housing 119 constituting a housing of the semiconductor manufacturing apparatus is provided below the substantially center portion in the front-rear direction in the housing 111 toward a rear end of the substrate processing apparatus 100.

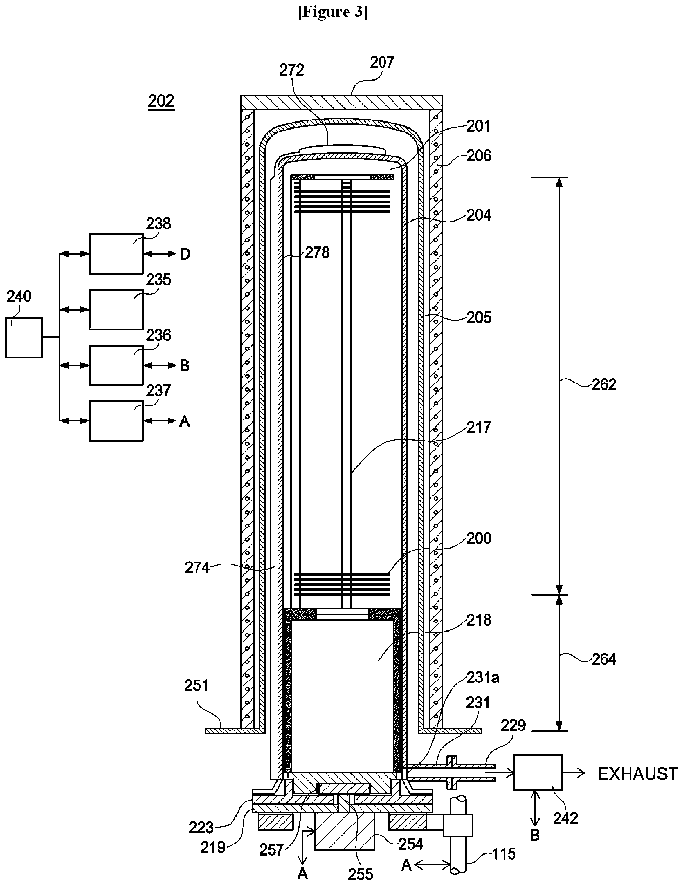

A pair of wafer loading/unloading ports (also referred to as "substrate loading/unloading ports") 120 are provided at a front wall 119a of the sub-housing 119. The wafer 200 shown in FIG. 3 may be loaded into or unloaded out of the sub-housing 119 through the pair of the wafer loading/unloading ports 120. The pair of the wafer loading/unloading ports 120 is arranged vertically in two stages. That is, an upper wafer loading/unloading port and a lower wafer loading/unloading port are provided as the pair of the wafer loading/unloading ports 120. A pair of pod openers including the pod opener 121 is provided at the pair of the wafer loading/unloading ports 120, respectively. For example, an upper pod opener and a lower pod opener may be provided as the pair of the pod openers. The upper pod opener and the lower pod opener may be collectively or individually referred to as the "pod opener 121".

The pod opener 121 includes a placement table 122 where the pod 110 is placed thereon and a cap attaching/detaching mechanism 123 configured to attach or detach a cap of the pod 110. By detaching or attaching the cap of the pod 110 placed on the placement table 122 by the pod opener 121, a wafer entrance of the pod 110 is opened or closed.

The sub-housing 119 defines a transfer chamber 124 fluidically isolated from an installation space in which the pod transport device 118 or the accommodating shelf 105 is provided. A wafer transport mechanism (also referred to as a "substrate transport mechanism") 125 is provided in a front region of the transfer chamber 124. The substrate transport mechanism 125 is constituted by a wafer transport device (also referred to as a "substrate transport device") 125a and a wafer transport device elevating mechanism (also referred to as a "substrate transport device elevating mechanism") 125b. The substrate transport device 125a is configured to support the wafer 200 by tweezers 125c and rotate or move the wafer 200 horizontally. The substrate transport device elevating mechanism 125b is configured to elevate or lower the substrate transport device 125a. The substrate transport mechanism 125 may load (charge) or unload (discharge) the wafer 200 into or out of a boat (also referred to as a "substrate retainer") 217 by consecutive operations of the substrate transport device elevating mechanism 125b and the substrate transport device 125a.

As shown in FIG. 3, a boat elevator 115 serving as an elevating mechanism described later is provided in the transfer chamber 124. The boat elevator 115 is configured to elevate or lower the boat 217. A lid 219 serving as a cover is provided horizontally at an arm serving as a connecting tool connected to the boat elevator 115. The lid 219 is configured to support the boat 217 vertically and to close a lower end of a process furnace 202 of the substrate processing apparatus 100. The boat 217 includes a plurality of support portions (also simply referred to as "support portions") (not shown) serving as a supporting part. The supporting part of the boat 217 is configured to support the plurality of the wafers (for example, 50 to 125 wafers) including the wafer 200 in horizontal orientation with their centers aligned concentrically in vertical direction with a predetermined interval therebetween.

The supporting part of the boat 217 is made of a material such as quartz (SiO₂), silicon carbide (SiC) and silicon (Si). The material of the supporting part may be selected according to a process temperature. For example, when the process temperature is equal to or less than 950°C, the supporting part may be made of quartz. When the process temperature is higher than 950°C, the supporting part may be made of SiC or Si. A fork portion of the supporting part of the boat 217 may be of various types depending on process conditions. For example, the fork portion may be short or long, or configured to have a small contact area with the wafer 200.

### <Pod Loading/unloading Operation of Substrate Processing Apparatus>

Next, a pod loading/unloading operation of the substrate processing apparatus 100 will be described. As shown in FIG. 1, when the pod 110 is placed on the load port shelf 114, the pod loading/unloading port 112 is opened by the front shutter 113. Then, the pod 110 placed on the load port shelf 114 is transported (loaded) into the housing 111 through the pod loading/unloading port 112 by the pod transport device 118.

The pod 110 transported into the housing 111 is automatically transported to and temporarily stored in a designated shelf plate among the shelf plates 117 of the accommodating shelf 105 by the pod transport device 118. The pod 110 is then transported toward one of the upper and lower pod openers 121 from the designated shelf plate and placed on the placement table 122. The pod 110 may be directly transported toward the one of the upper and lower pod openers 121 and placed on the placement table 122. Simultaneously, the pair of the wafer loading/unloading ports 120 are closed by the cap attaching/detaching mechanism 123, and the transfer chamber 124 is filled with clean air.

When the wafer entrance of the pod 110 placed on the placement table 122 is pressed against one of the pair of the wafer loading/unloading ports 120 of the front wall 119a of the sub-housing 119, the cap attaching/detaching mechanism 123 detaches the cap of the pod 110 and the wafer entrance of the pod 110 is opened. The wafer 200 is then transported out of the pod 110 by the tweezers 125c of the substrate transport device 125a, aligned by a notch alignment device (not shown), and transported and charged into the boat 217 (wafer charging). The substrate transport device 125a then returns to the pod 110 and transports a next wafer among the plurality of the wafers from the pod 110 into the boat 217.

While the substrate transport mechanism 125 loads the wafer 200 from the one of the upper and lower pod openers 121 into the boat 217, another pod 110 is transported by the pod transport device 118 to the other one of the upper and lower pod openers 121, and the cap of the aforementioned another pod 110 opened.

When a predetermined number of wafers including the wafer 200 are charged into the boat 217, the lower end of the process furnace 202 is opened by a furnace opening gate valve 147. Then, the lid 219 is elevated by the boat elevator 115 and the boat 217 supported by the lid 219 is loaded into the process furnace 202.

After the boat 217 is loaded into the process furnace 202, the plurality of the wafers including the wafer 200 are processed in the process furnace 202. After the plurality of the wafers are processed, the boat 217 is unloaded by the boat elevator 115 serving as an elevating mechanism. The plurality of the wafers and the pod 110 are unloaded out of the housing 111 in the order reverse to that described above except for an aligning process of the plurality of the wafers by the notch alignment device (not shown).

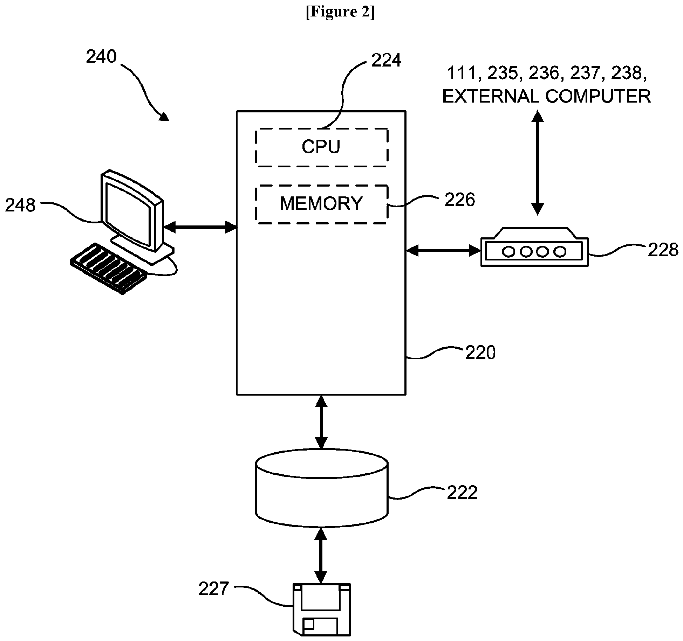

Subsequently, a configuration of a controller 240 serving as a control device will be described with reference to FIG. 2. The controller 240 may be embodied by a computer that includes a CPU (central processing unit) 224, a memory 226 such as a RAM (Random Access Memory) and a ROM (Read Only Memory) serving as a temporary memory device, a hard disk drive (HDD) 222 serving as a memory device, and a transmission/reception part 228 serving as a communication part. In addition to an instruction part 220 including at least the CPU 224 and the memory 226, the transmission/reception part 228 and the hard disk drive 222, the controller 240 may further include a display such as a liquid crystal display and a user interface device 248 serving as an operation part including a keyboard and a pointing device such as a mouse. For example, recipe files (not shown) containing recipes defining processing conditions and processing sequences, a control program file (not shown) containing a control program for executing the recipes, a parameter file (not shown) containing parameters for configuring the processing condition and the processing sequence and a display file (not shown) defining an input screen for entering process parameters are stored in the hard disk drive 222.

The transmission/reception part 228 of the controller 240 may be connected to a switching hub (not shown). The controller 240 may transmit and receive data to and from an external computer via a network using the transmission/reception part 228.

For example, the controller 240 is electrically connected to components such as a gas flow rate controller (hereinafter, also referred to as a "mass flow controller" or an "MFC") 235, a pressure controller 236, an operation controller 237 and a temperature controller 238 and sensors (not shown) provided in the housing 111 via a communication line through the transmission/reception part 228.

The controller 240 according to the first embodiment may be embodied by a general computer system as well as a dedicated system. The controller 240 may be embodied by installing the control program (also referred to as a "program") in the general computer system from a recording medium 227 such as a USB memory which stores the program. As described above, the program is configured to execute predetermined processes of the recipes.

The method of providing the program is not limited. For example, the program may be provided through the recording medium as described above, a communication line, a communication network or a communication system. In addition, the program may be posted on a bulletin board on the communication network, and may be provided by being superimposed on a carrier wave via the communication network. The program provided as described above may be executed to perform the above-described process under an OS (operating system) just like any other application programs.

### <Configuration of Process Furnace>

As shown in FIG. 3, the process furnace 202 includes a heater 206 serving as a heating apparatus (heating mechanism). The heater 206 is of a cylindrical shape, and is vertically installed while being supported by a support plate (also referred to as a "heater base") 251. An upper opening of the heater 206 is closed by a lid part 207.

A soaking tube (also referred to as an "outer tube") 205 is provided on an inner side of the heater 206 so as to be concentric with the heater 206. For example, the soaking tube 205 is made of a heat resistant material such as silicon carbide (SiC), and is of a cylindrical shape with a closed upper end and an open lower end.

A reaction tube (also referred to as an "inner tube") 204 is provided on an inner side of the soaking tube 205 so as to be concentric with the soaking tube 205. The reaction tube 204 is made of a heat resistant material such as quartz (SiO₂), and is of a cylindrical shape with a closed upper end and an open lower end. A process chamber 201 is provided in a hollow cylindrical portion of the reaction tube 204. The process chamber 201 is configured to accommodate vertically arranged wafers including the wafer 200 in a horizontal orientation in a multistage manner by the boat 217 described later. For example, a space between the reaction tube 204 and the soaking tube 205 is provided with a clearance of only about 30 mm. Therefore, a pipe with a large diameter cannot be provided in the space between the reaction tube 204 and the soaking tube 205.

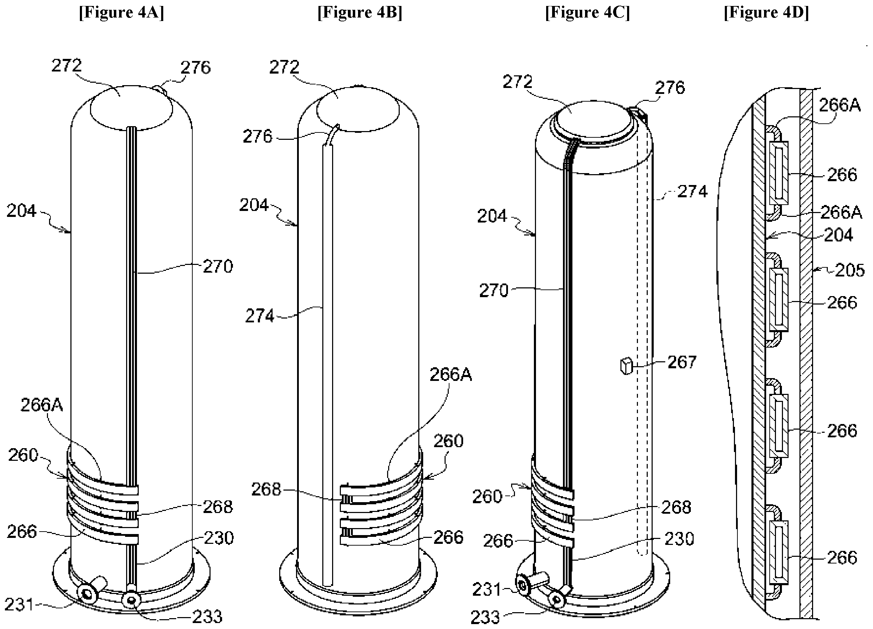

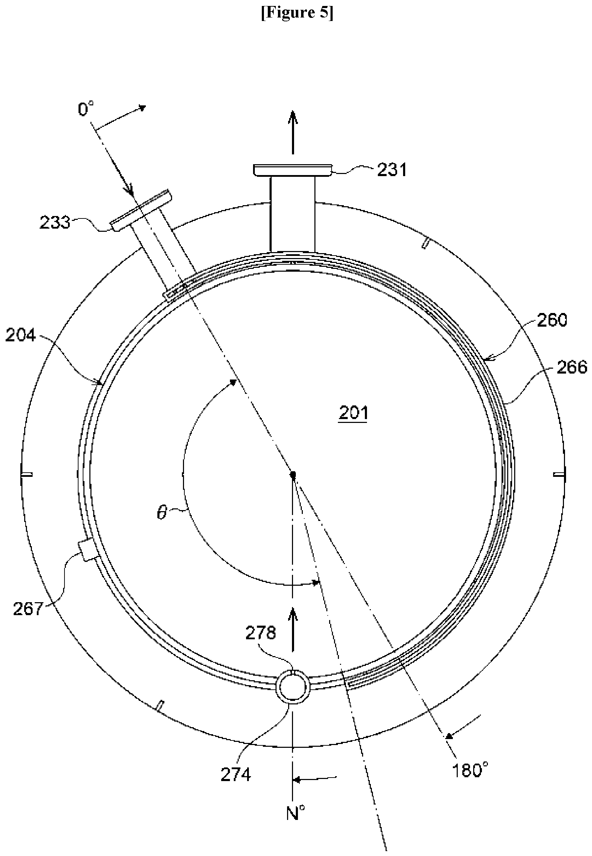

As shown in FIGS. 4A, 4C and 5, a gas introduction portion (hereinafter, also referred to as a "gas inlet") 233 of a pipe shape is provided at a lower end side of the reaction tube 204. A process gas is supplied into the reaction tube 204 through the gas introduction portion 233 from an outside of the reaction tube 204. A plurality of thin pipes (also simply referred to as "thin pipes", for example, three thin pipes according to the first embodiment) 230 extend upward from the gas introduction portion 233 along an outer peripheral surface of the reaction tube 204. A diameter of each of the thin pipes 230 is smaller than a diameter of the gas introduction portion 233, and a cross-section of each of the thin pipes 230 is of a circular shape. Upper ends of the thin pipes 230 are connected to a preheating portion 260 serving as a preheating path arranged on the outer peripheral surface of the reaction tube 204. The thin pipes 230 may be considered as a part of the gas introduction portion 233. The thin pipes 230 are fixed to the inner tube 204 such that each of the thin pipes 230 contacts the inner tube 204 and the thin pipes 230 are adjacent to each other. By providing the thin pipes 230, it is possible to increase a flow rate of a gas such as the process gas supplied into the inner tube 204 at one time. The thin pipes 230 may be thin enough to fit in the space between the inner tube 204 and the outer tube 205. A cross-sectional shape of each of the thin pipes 230 is not limited to the circular shape. For example, the cross-section of each of the thin pipes 230 may be of a rectangular shape. For example, the diameter of each of the thin pipes 230 may range from 5 mm to 8 mm. It is preferable that the diameter of each of the thin pipes 230 is 5 mm. In addition, the number of the thin pipes 230 may be two or more, for example, three or more.

The preheating portion 260 is connected to a plurality of thin pipes (also simply referred to as "thin pipes", for example, three thin pipes according to the first embodiment) 270. Similar to the thin pipes 230, the cross-section of each of the thin pipes 270 is of a circular shape. Configurations of the thin pipes 270 are essentially same as the thin pipes 230. The thin pipes 270 are connected to a nozzle pipe 274 via a buffer portion 272 provided at a ceiling of the reaction tube 204. The thin pipes 270 may also be referred to as a "first supplier" and the nozzle pipe 274 may also be referred to as a "second supplier". The process gas introduced through the gas introduction portion 233 via a plurality of gas holes (also simply referred to as "gas holes") 278 is supplied to the process chamber 201. The gas holes 278 serve as a gas supplier, and are provided at the nozzle pipe 274 arranged on the outer peripheral surface of the reaction tube 204.

In the present specification, the term "pipe member" refers to a assembly that communicates the gas introduction portion 233 to the gas holes 278. That is, components described above such as the thin pipes 230, the preheating portion 260, the thin pipes 270, the buffer portion 272, the nozzle pipe 274 and a thin pipe 276 described later may be collectively referred to as the "pipe member". However, the pipe member is not limited to the configuration of the first embodiment including the thin pipes 230, the preheating portion 260, the thin pipes 270, the buffer portion 272, the nozzle pipe 274 and the thin pipe 276. In addition, as shown in FIG. 3, the pipe member is provided outside the reaction tube 204. That is, the pipe member is provided between the reaction tube 204 and the heater 206. For example, the diameter of each of the thin pipes 230, the diameter of each of the thin pipes 270 and a diameter of thin pipe 276 are the same.

### <Configuration of Preheating Portion>

According to the first embodiment, a region of a side surface (hereinafter, also referred to as a "side wall") of the reaction tube 204 facing the plurality of the wafers including the wafer 200 to be processed by the gas in the reaction tube 204 may be referred to as a wafer processing region (also referred to as a "substrate processing region") 262, and a region below the wafer processing region 262 where the preheating portion 260 is disposed may be referred to as a gas preheating region 264. In the gas preheating region 264, the preheating portion 260 is provided on the side surface of the reaction tube 204 at a position lower than the wafer processing region 262 where the plurality of the wafers including the wafer 200 are disposed in the process chamber 201. The preheating portion 260 extends in a direction detouring from a direction from the gas introduction portion 233 toward the ceiling of the reaction tube 204. For example, the preheating portion 260 is configured to extend in a direction intersecting with the direction in which the process gas introduced through the gas introduction portion 233 flows to the ceiling of the reaction tube 204 at a shortest distance. In addition, for example, at least a part of the preheating portion 260 is provided to extend in an outer peripheral direction of the reaction tube 204. Hereinafter, the preheating portion 260 will be described in detail with reference to the drawings.

As shown in FIGS. 4A through 5, the preheating portion 260 includes a plurality of preheating pipes (also simply referred to as "preheating pipes", for example, four preheating pipes according to the first embodiment) 266 extending in a circumferential direction of the reaction tube 204 over a range of approximately 190°. The preheating pipes 266 are arranged in a multistage manner in the vertical direction. End sides of the preheating pipes 266 adjacent to each other are alternately connected by a plurality of connecting pipes (also simply referred to as "connecting pipes", for example, three connecting pipes according to the first embodiment) 268. A diameter of each of the connecting pipes 268 is smaller than a diameter of each of the preheating pipes 266, and a cross-section of each of the connecting pipes 268 is of a circular shape. The preheating portion 260 constitutes the preheating path of a rectangular waveform shape (two cycles, two reciprocations) as a whole. According to the first embodiment, the connecting pipes 268 correspond to a first preheating portion, and the preheating pipes 266 correspond to a second preheating portion. The preheating portion 260 is configured by combining the connecting pipes 268 and the preheating pipes 266. A starting point and an ending point of the preheating path are located at the preheating pipes 266. the connecting pipes 268 is provided between a position of the preheating pipes 266 and another position of the preheating pipes 266.The angular range in which the preheating pipes 266 are located in the circumferential direction of the reaction tube 204 is determined as desired according to a positional relationship between the gas introduction portion 233 and the nozzle pipe 274. For example, the angular range in which the preheating pipes 266 are located in the circumferential direction of the reaction tube 204 is determined by an angular range from an angular position of the gas introduction portion 233 to an angular position of the nozzle pipe 274 in the circumferential direction. For example, as shown in FIG. 5, when the angular position where the gas introduction portion 233 is disposed is set to 0° and the angular position where the nozzle pipe 274 is disposed is set to N° (N is a positive number equal to or less than 360), the angular range in which the preheating pipes 266 are located in the circumferential direction of the reaction tube 204 may be set to be greater than 0° and less than N°. In addition, the angular range in which the preheating pipes 266 are located in the circumferential direction of the reaction tube 204 may be set to be greater than 180° and less than N°. As described above, for example, the angular range in which the preheating pipes 266 are located in the circumferential direction of the reaction tube 204 may be set to 190°. By providing the preheating pipes 266 in the circumferential direction of the reaction tube 204, it is possible to lengthen the preheating path. According to the first embodiment, a configuration of each of the connecting pipes 268 is the same as that of each of the thin pipes 230 (or the thin pipes 270). According to the first embodiment, cross-sectional areas of flow paths of the connecting pipes 268 are set to be essentially the same as cross-sectional areas of flow paths of the thin pipes (for example, three thin pipes) 230 or the thin pipes (for example, three thin pipes) 270. In addition, as shown in FIGS. 4C and 5, a temperature sensor 267 serving as a temperature detecting device is provided in a space (cylindrical space) between the reaction tube 204 and the soaking tube 205 (not shown in FIGS. 4C and 5). Preferably, the temperature sensor 267 is provided on the space opposite to the preheating pipes 266 so as not to be in contact with or close to the preheating pipes 266. That is, when the preheating pipes 266 and the temperature sensor 267 are close to each other, the temperature sensor 267 intended to detect an inner temperature of the reaction tube 204 may detect a temperature of the preheating pipes 266 instead of the inner temperature of the reaction tube 204. Specifically, the angular range in which the preheating pipes 266 are located in the circumferential direction of the reaction tube 204 is from the angular position of the gas introduction portion 233 to an angular position of the temperature sensor 267 in the circumferential direction of the reaction tube.

As shown in FIG. 4D, since the space between the reaction tube 204 and the soaking tube 205 is very narrow as described above, a pipe whose vertical cross-section is of a rectangular shape may be used as each of the preheating pipes 266 according to the first embodiment. By adjusting the shape of the pipe serving as each of the preheating pipes 266 to be same as a vertical cross-sectional shape of the space (also referred to as a "gap") between the reaction tube 204 and the soaking tube 205, it is possible to enlarge a cross-sectional shape (that is, a cross-sectional area) of the preheating path. As a result, it is possible to increase the flow rate of the gas such as the process gas passing through the preheating path. In addition, the preheating pipes 266 and the connecting pipes 268 constituting the preheating portion 260 are provided close to or in contact with the outer peripheral surface of the reaction tube 204, and are configured to transfer the heat from the heater 206 and the heat from the reaction tube 204 to the gas passing through the preheating path in the preheating pipes 266 and the connecting pipes 268. According to the first embodiment, the cross-sectional shapes of the thin pipes 230 and the connecting pipes 268 are different from the cross-sectional shapes of the preheating pipes 266 in the gas preheating region 264. Therefore, connecting parts between the thin pipes 230 and the preheating pipes 266 and connecting parts between the connecting pipes 268 and the preheating pipes 266 of the preheating portion 260 are configured to mix the gas passing through the preheating path. Thus, the gas introduced through the thin pipes 230 is supplied into the thin pipes 270 via the preheating portion 260 while a temperature of the gas at the connecting parts is uniformized. As the number of the connecting parts increases, the effect of maintaining the temperature of the gas by mixing the gas at the connecting parts becomes remarkable. By reducing the length of each of the preheating pipes 266 in the vertical direction, it is possible to increase the number of the connecting parts between the connecting pipes 268 and the preheating pipes 266. However, by reducing the length of each of the preheating pipes 266, the cross-sectional area of the preheating path of the preheating pipes 266 is also reduced. As a result, the flow rate of the gas passing through the preheating path is also reduced. Therefore, according to the first embodiment, the preheating portion 260 is configured such that the cross-sectional areas of the flow paths of the thin pipes 230 or the cross-sectional area of the preheating path in the connecting pipes 268 are equal to or less than the cross-sectional area of the preheating path in the preheating pipes 266, and the gas may pass through the preheating path in the connecting pipes 268 and the preheating path in the preheating pipes 266 a plurality of times. In addition, as shown in FIG. 4A, 4B and 4D, the preheating pipes 266 are fixed to the reaction tube 204 via a plurality of mounting portions (also simply referred to as "mounting portions") 266A. The mounting portions 266A are provided in the outer peripheral direction of the reaction tube 204. When the preheating pipes 266 are brought into contact with and fixed (welded) to the reaction tube 204, (i) the inner temperature of the reaction tube 204 (or the process chamber 201) may decrease due to the gas flowing in the preheating pipes 266, (ii) the flow rate of the gas may decrease due to the welding deformation of the preheating pipes 266 and (iii) dimensional variations in the clearance and interferences with the components in the reaction tube 204 such as the boat 217 may occur due to the welding deformation of the reaction tube 204. Therefore, in order to address the risks described above, a structure shown in FIG. 4D may be used. According to the structure shown in FIG. 4D, it is possible to reduce welding portions (or welding areas) and contact areas with the reaction tube 204 as much as possible. Therefore, it is possible to reduce the risks caused by the welding areas and the contact areas.

The upper ends of the thin pipes 230 extending from the gas introduction portion 233 are connected to the end of a lowermost preheating pipe among the preheating pipes 266 constituting the preheating portion 260, and the lower ends of the thin pipes 270 extending upward are connected to the end of a uppermost preheating pipe among the preheating pipes 266.

### <Buffer Portion 272>

The buffer portion 272 serving as a circular buffer box is provided at an uppermost part of the reaction tube 204 (that is, on the ceiling of the reaction tube 204). The upper ends of the thin pipes 270 extending from the preheating portion 260 are connected to the buffer portion 272 on one side in a radial direction of the buffer portion 272 such that the gas passing through the preheating portion 260 is introduced into the buffer portion 272.

The nozzle pipe 274 extending in the vertical direction is provided at the outer peripheral surface of the reaction tube 204 opposite to the thin pipes 230 and the thin pipes 270. Specifically, the nozzle pipe 274 serves as a part of the side wall of the reaction tube 204, and a part of the nozzle pipe 274 is provided so as to protrude into the space between the reaction tube 204 and the soaking tube 205. An upper end of the nozzle pipe 274 is connected to the buffer potion 272 via the thin pipe 276 with a small diameter so that the gas passing through the buffer portion 272 is introduced into the nozzle pipe 274. A horizontal cross-section of the nozzle pipe 274 is of a circular shape, and a diameter of the nozzle pipe 274 is greater than a diameter of the thin pipe 276. For example, the diameter of the nozzle pipe 274 is greater than 20 mm, preferably about 50 mm. The thin pipe 276 may be included in a part of the nozzle pipe 274.

The gas holes 278 shown in FIG. 5 configured to eject the gas into the reaction tube 204 are provided at the nozzle pipe 274 from a lower end to the upper end of the nozzle pipe 274 at a predetermined interval (a constant interval) along the longitudinal direction. The gas holes 278 are arranged between the plurality of the wafers including the wafer 200 at the same interval as the interval between the supporting portions of the boat 217 configured to support the plurality of the wafers. The gas holes 278 are provided at the nozzle pipe 274 so as to eject the gas between the plurality of the wafers including the wafer 200.

As shown in FIGS. 3 through 5, a gas exhaust portion (also referred to as an "exhaust portion" or a "gas outlet") 231 of a pipe shape is provided at the lower side of the reaction tube 204 opposite to the nozzle pipe 274. The gas exhaust portion 231 is configured to discharge (exhaust) an inner atmosphere of the reaction tube 204 to the outside of the reaction tube 204. As shown in FIGS.4A and 4B, the gas exhaust portion 231 is provided closer to the gas introduction portion 233 than to the nozzle pipe 274. Specifically, the gas exhaust portion 231 is located at a position of the reaction tube 204 opposite to the other position where the nozzle pipe 274 is located. An angular position of the gas exhaust portion 231 is between the angular position of the gas introduction portion 233 and the angular position of the nozzle pipe 274. The gas exhaust portion 231 is provided lower than the preheating pipes 266.

As shown in FIG. 3, a process gas supply source (not shown), a carrier gas supply source (not shown) and an inert gas supply source (not shown) are connected to an upstream side of the gas introduction portion 233 via the MFC (that is, the gas flow rate controller) 235. The MFC 235 is configured to control the flow rate of the gas supplied into the process chamber 201 to a desired flow rate at a desired timing. A gas supply system according to the first embodiment is constituted by at least the process gas supply source, the carrier gas supply source, the inert gas supply source and the MFC 235.

A sequencer (not shown) is configured to control the supply or the stop of the supply of the gas by opening and closing a valve (not shown). The controller 240 is configured to control the MFC 235 and the sequencer to adjust the flow rate of the gas supplied into the process chamber 201 to the desired flow rate at the desired timing.

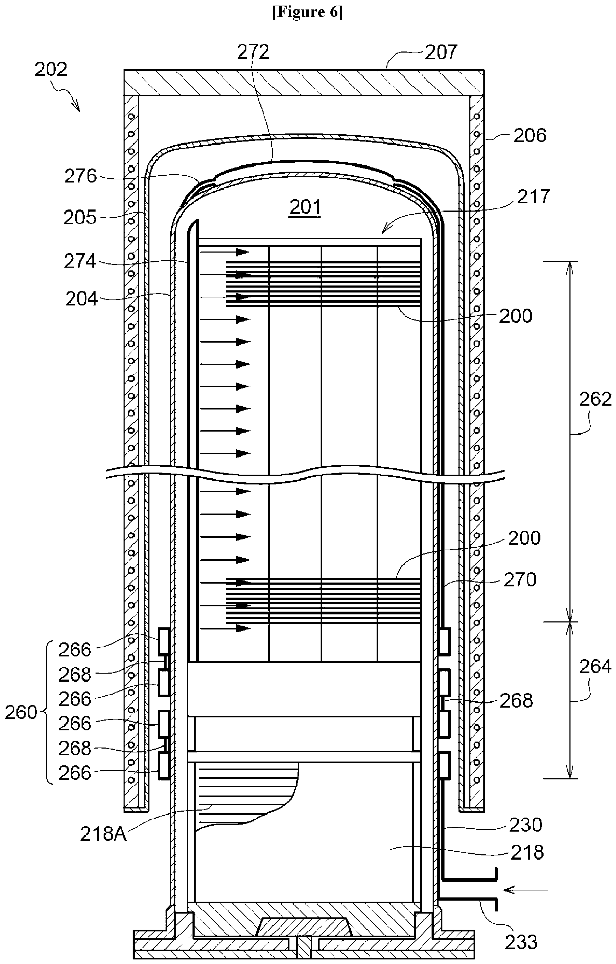

FIG. 6 schematically illustrates the process furnace 202 when the boat 217 is loaded into the reaction tube 204. In FIG. 6, only some of the plurality of the wafers including the wafer 200 are shown for simplification. Horizontal arrows in FIG. 6 indicate flows (directions) of the process gas. In a heat insulating region of the boat 217 (that is, a region where a plurality of heat insulating plates (also simply referred to as "heat insulating plates") 218A of a heat insulating cylinder 218 described later is accommodated), a distance (pitch) between adjacent heat insulating plates among the heat insulating plates 218A is about ten millimeters, and the distances between the gas holes 278 of the nozzle pipe 274 (not shown in FIG. 6) are also set to be equal to the pitch of the heat insulating plates 218A. A lowermost gas hole among the gas holes 278 (not shown in FIG. 6) is provided at a position facing the gas exhaust portion 231 shown in FIG. 5.

As described above, it is possible to supply the gas to the lower end of the boat 217 (the position facing the gas exhaust portion 231) by providing the gas holes 278 at the lower end of the boat 217. Therefore, it is possible to eliminate the gas stagnation at the lower end of the boat 217. In particular, even in the heat insulating region, by supplying the gas into the process chamber 201 through the gas holes 278, it is possible to form the flow of the gas on each of the surface of the heat insulating plates 218A. In this manner, it is possible to form the flow of the gas the same as the gas in the wafer processing region 262. Therefore, it is possible to suppress the particles due to the gas stagnation at a lower end of the wafer processing region 262.

The gas is continuously heated by the heat from the reaction tube 204 and the heat from the heater 206 while the gas temporarily stagnates in the buffer portion 272 described above. Then, the gas sufficiently heated by the heat is ejected through the gas holes 278 of the nozzle pipe 274 and supplied into the process chamber 201. As a result, it is possible to reduce temperature differences between the gas supplied into the process chamber 201 and components constituting the process chamber 201 such as a SiC component, a quartz component and the wafer 200. Therefore, it is possible to reduce the particles due to the temperature differences.

As shown in FIG. 3, a support body 257 serving as a base flange capable of hermetically sealing a lower end opening of the reaction tube 204 and the lid 219 are provided at a lower end of the reaction tube 204. For example, the lid 219 is made of a metal such as stainless steel and is of a disk shape. For example, the support body 257 provided on the lid 219 is made of quartz and is of a disk shape. An O-ring 223 serving as a sealing part in contact with the lower end of the reaction tube 204 is provided on an upper surface of the support body 257.

A rotating mechanism 254 configured to rotate the boat 217 is provided on the lid 219 opposite to the process chamber 201. A rotating shaft 255 of the rotating mechanism 254 is connected to the heat insulating cylinder 218 and the boat 217 through the lid 219 and the support body 257. The rotating mechanism 254 rotates the heat insulating cylinder 218 and the boat 217 to rotate the plurality of the wafers including the wafer 200.

The lid 219 is elevated or lowered in the vertical direction by the boat elevator 115 vertically installed outside the reaction tube 204 so as to load the boat 217 into or unload the boat 217 out of the process chamber 201. The operation controller 237 is electrically connected to the rotating mechanism 254 and the boat elevator 115. The operation controller 237 may control the rotating mechanism 254 and the boat elevator 115 such that the rotating mechanism 254 and the boat elevator 115 perform a desired operation at a desired timing.

The boat 217 is made of a heat resistant material such as quartz and silicon carbide (SiC), and is configured to support the plurality of wafers including the wafer 200 vertically arranged in a horizontal orientation in a multistage manner with their centers aligned. The heat insulating cylinder 218 serving as a heat insulating member is provided below the boat 217 to support the boat 217. For example, the heat insulating cylinder 218 is made of a heat resistant material such as quartz and silicon carbide and is of a cylindrical shape. The heat insulating cylinder 218 is configured to suppress the heat emitted from the heater 206 from being transmitted to the lower end portion of the reaction tube 204.

The temperature controller 238 is electrically connected to the heater 206 and the temperature sensor 267. The temperature controller 238 is configured to adjust a state of electric conduction to the heater 206 based on the temperature detected by the temperature sensor 267 such that an inner temperature of the process chamber 201 reaches and is maintained at a desired temperature at a desired timing.

An exhaust pipe 229 is connected to the gas exhaust portion 231. A pressure adjusting device 242 including at least an APC (Automatic Pressure Controller) valve and an exhaust device (not shown) are connected to a downstream side of the exhaust pipe 229. An exhaust system is constituted by the components described above such as the exhaust pipe 229, the pressure adjusting device and the exhaust device. The pressure controller 236 is electrically connected to the pressure adjusting device 242 and the exhaust device. The pressure controller 236 may be configured to control the exhaust system such that an inner pressure of the process chamber 201 reaches and is maintained at a predetermined pressure.

### <Operations and Effects of First Embodiment>

Subsequently, a method of performing a substrate processing such as an oxidation process and a diffusion process (particularly, the substrate processing such as a PYRO oxidation process, a DRY oxidation process and an annealing process) on the wafer 200, which is a part of manufacturing processes of a semiconductor device, will be described. The substrate processing may be performed using the process furnace 202 of the substrate processing apparatus 100. In the following description, the operations of the components constituting the substrate processing apparatus 100 are controlled by the controller 240.

After the plurality of wafers including the wafer 200 are transported (charged) into the boat 217 (wafer charging), the boat 217 charged with the plurality of wafers is elevated by the boat elevator 115 and transferred (loaded) into the process chamber 201 (boat loading). With the boat 217 loaded, the lid 219 seals the lower end of the reaction tube 204 via the support body 257 and the O-ring 223.

The process chamber 201 is heated by the heater 206 such that the inner temperature of the process chamber 201 reaches and is maintained at the desired temperature. The electric conduction state to the heater 206 is feedback-controlled based on the temperature detected by the temperature sensor 267 such that the inner temperature of the process chamber 201 has a predetermined temperature distribution. Subsequently, the rotating mechanism 254 rotates the heat insulating cylinder 218 and the boat 217 to rotate the plurality of wafers including the wafer 200.

Subsequently, the gas supplied through the process gas supply source (not shown) and the carrier gas supply source (not shown) and adjusted (controlled) to the desired flow rate by the MFC 235 is introduced into the gas introduction portion 233. The gas introduced into the gas introduction portion 233 at the lower side of the reaction tube 204 flows through the thin pipes 230, and is introduced into the nozzle pipe 274 via the preheating portion 260, the thin pipes 270 and the buffer portion 272. Then, the gas is introduced into the process chamber 201 through the gas holes 278.

The gas introduced into the gas introduction portion 233 is preheated at the preheating portion 260 by the heat from the heater 206 and the heat from the reaction tube 204, and passes through the thin pipes 270 in the wafer processing region 262 after the temperature of the gas is sufficiently increased. Therefore, it is possible to suppress the decrease in the temperature of the wafer processing region 262. As a result, it is possible to uniformize the temperature of the wafer processing region 262 facing the plurality of the wafers including the wafer 200 in the reaction tube 204.

When the gas introduced into the gas introduction portion 233 passes through the wafer processing region 262 without preheating, the gas with a low temperature may pass through the thin pipes 270, the temperature of a portion where the thin pipes 270 are arranged may decrease and the temperature of the reaction tube 204 may become uneven (nonuniform). As a result, a temperature uniformity of the plurality of the wafers including the wafer 200 may be adversely affected.

The gas heated by passing through the preheating portion 260 is ejected into the process chamber 201 through the gas holes 278 provided in the nozzle pipe 274 via the buffer portion 272. The gas ejected through the gas holes 278 comes into contact with the surface of the wafer 200 when passing through the process chamber 201. As a result, the process such as the oxidation process and the diffusion process is performed onto the wafer 200. As the boat 217 is rotated, the wafer 200 is also rotated such that the gas contacts the entire surface of the wafer 200.

Since the temperature of the wafer processing region 262 facing the plurality of wafers including the wafer 200 is uniformized, it is possible to uniformly heat the plurality of wafers including the wafer 200.

In addition, by exhausting the process chamber 201 by an ejector (not shown) provided at a downstream side of the gas exhaust portion 231, the gas with a uniform flow rate is supplied through each of the gas holes 278 to the process chamber 201 at a predetermined flow rate. Thereby, it is possible to quickly exhaust an outgas during a heat treatment process to the exhaust system.

When a process using water vapor is performed onto the wafer 200, the flow rate of the gas is adjusted to a desired flow rate by the MFC 235, and the gas with the flow rate thereof adjusted is then supplied to a water vapor generator (not shown). Then, the gas containing the water vapor (H₂O) generated by the water vapor generator is supplied into the process chamber 201.

After a predetermined processing time has elapsed, an inert gas is supplied through inert gas supply source to replace an inner atmosphere of the process chamber 201 with an inert gas, and the inner pressure of the process chamber 201 is returned to normal pressure.

Thereafter, the lid 219 is lowered by the boat elevator 115 and the lower end of the reaction tube 204 is opened. Then, the processed wafers including the wafer 200 charged in the boat 217 are unloaded out of the reaction tube 204 through the lower end of the reaction tube 204 (boat unloading). The processed wafers 200 are then discharged from the boat 217 (wafer discharging).

As described above, in the substrate processing apparatus 100 according to the first embodiment, the gas passing through the thin pipes 270 provided at the wafer processing region 262 is sufficiently preheated at the preheating portion 260, and the influence of the temperature of the gas passing through the thin pipes 270 on the wafer processing region 262 is suppressed. As a result, since the temperature of the wafer processing region 262 facing the plurality of wafers including the wafer 200 is uniformized, it is possible to suppress the processing failure of the wafer 200 due to the nonuniform temperature of the wafer processing region 262.

### <Second Embodiment>

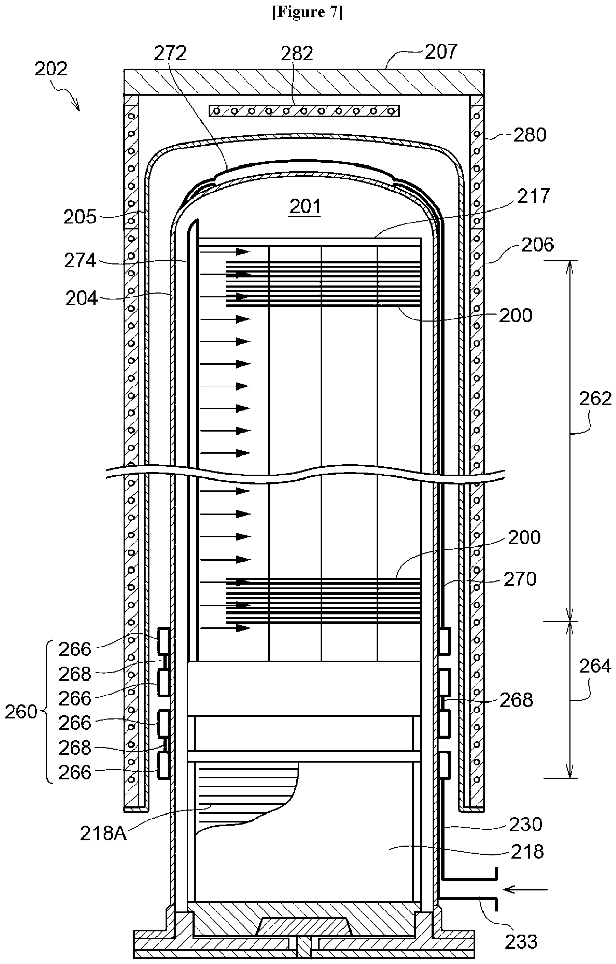

Hereinafter, a substrate processing apparatus 100 according to a second embodiment will be described with reference to FIG. 7. The same components as those of the first embodiment will be denoted by like reference numerals, and detailed description thereof will be omitted.

As shown in FIG. 7, in the substrate processing apparatus 100 according to the second embodiment, an upper heater 280 of a cylindrical shape is provided above the heater 206. The upper heater 280 is provided so as to face the buffer portion 272 at a radially outer side of the buffer portion 272. In addition, the upper heater 280 is provided so as not to face the plurality of the wafers including the wafer 200 to be processed by the gas in the reaction tube 204 at radially outer sides of the plurality of the wafers. That is, the upper heater 280 is provided above the wafer processing region 262. A ceiling heater 282 of a plate shape is provided above the soaking tube 205. It is possible to adjust (set) temperatures of the upper heater 280 and the ceiling heater 282 differently by the controller 240.

In the substrate processing apparatus 100 according to the second embodiment, it is possible to heat the gas stagnated in the buffer part 272 by at least one among the upper heater 280 and the ceiling heater 282. Therefore, it is possible to process the wafer 200 by supplying the gas with a higher temperature than that of the first embodiment into the process chamber 201 of the reaction tube 204. Accordingly, the gas such as the process gas can be supplied into the process chamber 201 while reducing a temperature difference between the process gas and components constituting the process chamber 201. As a result, it is possible to reduce the particles due to the temperature difference. Other operations and effects of the second embodiment are the same as those of the first embodiment.

### <Third Embodiment>

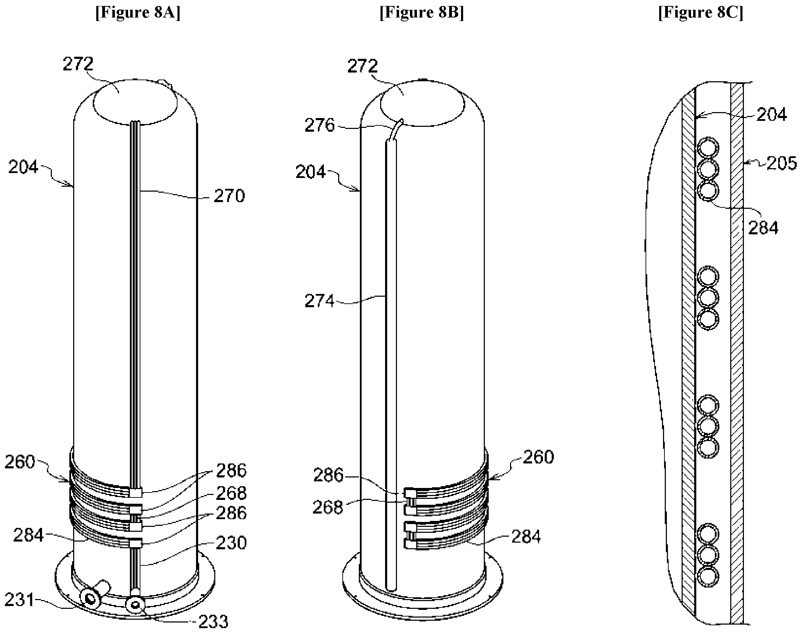

Hereinafter, a substrate processing apparatus 100 according to a third embodiment will be described with reference to FIGS. 8A through 8C. The same components as those of the first embodiment will be denoted by like reference numerals, and detailed description thereof will be omitted.

As shown in FIGS. 8A through 8C, in the substrate processing apparatus 100 according to the third embodiment, the preheating pipes 266 of the preheating portion 260 of the first embodiment is replaced with a plurality of preheating pipes (also simply referred to as "preheating pipes", for example, three preheating pipes whose cross-sections are of a circular shape according to the third embodiment) 284. As described above, the cross-section of each of the preheating pipes 266 is of a rectangular shape. The preheating pipes 284 may also be referred to as a "main preheating portion". A plurality of joints (also simply referred to as "joints") 286 are configured to connect the preheating pipes 284 and the connecting pipes 268, the preheating pipes 284 and the thin pipes 230, and the preheating pipes 284 and the thin pipes 270, respectively. The preheating pipes 284 and the joints 286 correspond to a second preheating portion according to the third embodiment. A pipe whose vertical cross-section is of a rectangular shape is used as each of the connecting pipes 268 according to the third embodiment. Thus, a cross-sectional shape of each of the connecting pipes 268 of the third embodiment is different from those of the connecting pipes 268 of the first embodiment, the preheating pipes 284, the thin pipes 230 and the thin pipes 270, whose cross-sections are of a circular shape. According to the third embodiment, a thin pipe is used as each of the preheating pipes 284. However, since a set of three thin pipes are used as the preheating pipes 284, it is possible to increase a cross-sectional area of the flow path of the preheating pipes 284. Therefore, it is possible to sufficiently preheat the gas similarly to the preheating pipes 266 of the first embodiment. Other operations and effects of the third embodiment are the same as those of the first and second embodiments.

### <Test Examples>

The test is performed using two types of reaction tubes according to comparative examples (that is, a first comparative example and a second comparative example) and three types of reaction tubes according to examples (that is, a first example, a second example and a third example) of the embodiments in which the preheating path described above is provided. Test results obtained by comparing and verifying the reaction tubes according to the first comparative example, the second comparative example, the first example, the second example and the third example will be described below. In the following description and the drawings illustrating the comparative examples and the examples, the same components as those of the embodiments described above will be denoted by like reference numerals, and detailed description thereof will be omitted.

The nozzle pipe 274 and an internal structure of the reaction tube 204 according to each of the comparative examples and the examples are the same. However, according to each of the comparative examples and the examples, a configuration of a gas path from the gas introduction portion 233 to the nozzle pipe 274 is different. Hereinafter, differences between the gas paths according to the comparative examples and the examples will be described.

### <First Comparative Example>

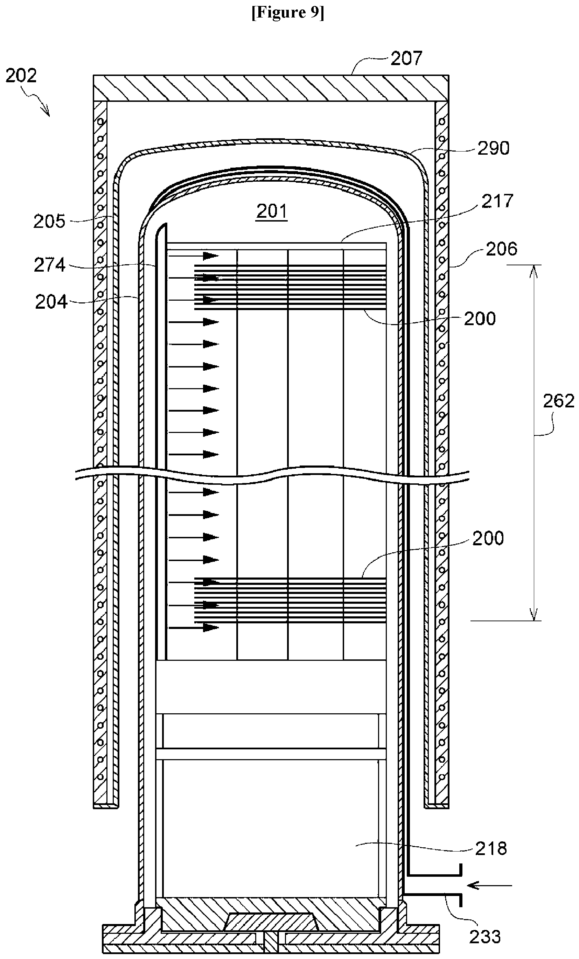

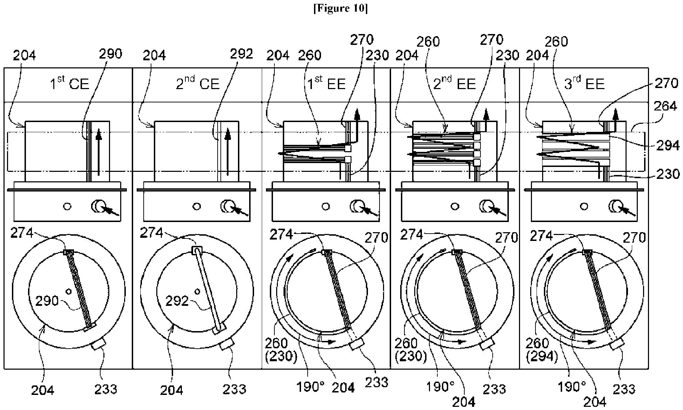

As shown in FIGS. 9 and 10, according to the first comparative example (indicated by "1^{st} CE" in FIGS. 10 through 12), three thin pipes 290 extending upward on the outer surface of the reaction tube 204 from the gas introduction portion 233 are directly connected to the nozzle pipe 274 across the uppermost side of the reaction tube 204. For example, an inner diameter Φ of each of the three thin pipes 290 is 5 mm. According to the first comparative example, no preheating path is provided.

### <Second Comparative Example>

As shown in FIG. 10, according to the second comparative example (indicated by "2^{nd} CE" in FIGS. 10 through 12), a thin pipe 292 extending upward on the outer surface of the reaction tube 204 from the gas introduction portion 233 is directly connected to the nozzle pipe 274 across the uppermost side of the reaction tube 204. For example, an inner diameter Φ of the thin pipe 292 is 21 mm. According to the second comparative example, no preheating path is provided.

### <First Example>

As shown in FIG. 10, according to the first example of the embodiments (indicated by "1^{st} EE" in FIGS. 10 through 12), the thin pipes (three thin pipes) 230 extend upward on the outer surface of the reaction tube 204 from the gas introduction portion 233 to the preheating portion 260. For example, an inner diameter Φ of each of the three thin pipes 230 is 5 mm. The thin pipes (three thin pipes) 270 extending upward from the preheating portion 260 are connected to the nozzle pipe 274 across the uppermost side of the reaction tube 204. According to the first example, the preheating portion 260 is configured by disposing the three thin pipes 230 serving as preheating pipes in the circumferential direction of the reaction tube 204 over a range of 190° and reciprocating the preheating path once.

### <Second Example>

As shown in FIG. 10, according to the second example of the embodiments (indicated by "2^{nd} EE" in FIGS. 10 through 12), the thin pipes (three thin pipes) 230 extend upward on the outer surface of the reaction tube 204 from the gas introduction portion 233 to the preheating portion 260. For example, the inner diameter Φ of each of the three thin pipes 230 is 5 mm. The thin pipes (three thin pipes) 270 extending upward from the preheating portion 260 are connected to the nozzle pipe 274 across the uppermost side of the reaction tube 204. According to the second example, the preheating portion 260 is configured by disposing the three thin pipes 230 serving as the preheating pipes in the circumferential direction of the reaction tube 204 over a range of 190° and reciprocating the preheating path twice.

### <Third Example>

As shown in FIG. 10, according to the third example of the embodiments (indicated by "3^{rd} EE" in FIGS. 10 through 12), the thin pipes (three thin pipes) 230 extend upward on the outer surface of the reaction tube 204 from the gas introduction portion 233 to the preheating portion 260. For example, the inner diameter Φ of each of the three thin pipes 230 is 5 mm. The thin pipes (three thin pipes) 270 extending upward from the preheating portion 260 are connected to the nozzle pipe 274 across the uppermost side of the reaction tube 204. According to the third example, the preheating portion 260 is configured by disposing a rectangular pipe 294 in the circumferential direction of the reaction tube 204 over a range of 190° and reciprocating the preheating path twice. A cross-section of the rectangular pipe 294 is of a rectangular shape with dimensions of 24 × 3 mm.

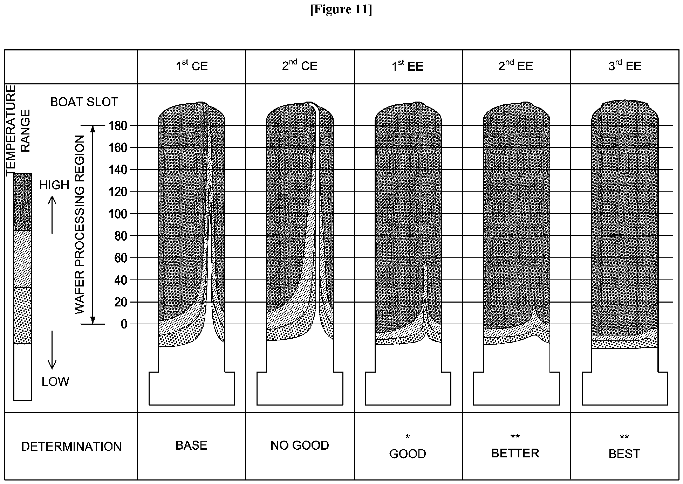

FIG. 11 schematically illustrates the test results in which temperatures of inner walls of the reaction tubes (that is, temperature distributions) according to the first comparative example, the second comparative example, the first example, the second example and the third example are represented as differences in concentration. In FIG. 11, the higher the concentration (the darker the concentration), the higher the temperature. As shown in FIG. 11, according to the first comparative example and the second comparative example, temperature at position of the reaction tube 204 where the thin pipes 290 extending upward from the gas introduction portion 233 or the thin pipe 292 extending upward is provided are lower than temperature at position of the reaction tube 204 where the thin pipes 290 or the thin pipe 292 is not provided. That is, according to the first comparative example and the second comparative example, the temperature of the reaction tube 204 is uneven (nonuniform). As shown in FIG. 11, according to the first example, the second example and the third example, it is possible to suppress the unevenness (nonuniformity) in the temperature of the reaction tube 204 as compared with the first comparative example and the second comparative example.

The preheating path of the preheating portion 260 of each of the examples (that is, the first example, the second example and the third example) is longer than that of each of the comparative examples (that is, the first comparative example and the second comparative example). Therefore, according to the examples, the gas is preheated more efficiently and the influence of the gas passing through the thin pipes 270 is reduced. Therefore, according to the examples, it is possible to suppress the unevenness (nonuniformity) in the temperature of the reaction tube 204 as compared with the comparative examples. The preheating path of the preheating portion 260 of each of the second example and the third example is longer than that of the first example. Therefore, according to the second example and the third example, the gas is preheated more efficiently and the influence of the gas passing through the thin pipes 270 is more reduced. Therefore, according to the second example and the third example, it is possible to suppress the unevenness (nonuniformity) in the temperature of the reaction tube 204 as compared with the first example. The cross-sectional area (or dimensions) of the preheating path of the preheating portion 260 of the third example is greater than that the cross-sectional area (or inner diameter) of the preheating path of the preheating portion 260 of the second example. Therefore, according to the third example, the gas is preheated more efficiently and the influence of the gas passing through the thin pipes 270 is more reduced. Therefore, according to the third example, it is possible to suppress the unevenness (nonuniformity) in the temperature of the reaction tube 204 as compared with the second example. In particular, according to the third embodiment, since the cross-sectional area (or dimensions) of the preheating path of the preheating portion 260 is large and the preheating path is long, an area where the gas is applied to the heat in the pre-heating portion 260 and a contact time during the gas being applied to the heat in the pre-heating portion 260 are increased as compared with the comparative examples, the first example and the second example. Therefore, the temperature of the gas is sufficiently increased before flowing into the thin pipes 270. As a result, it is possible to substantially eliminate the temperature unevenness (nonuniformity) in the wafer processing region 262.

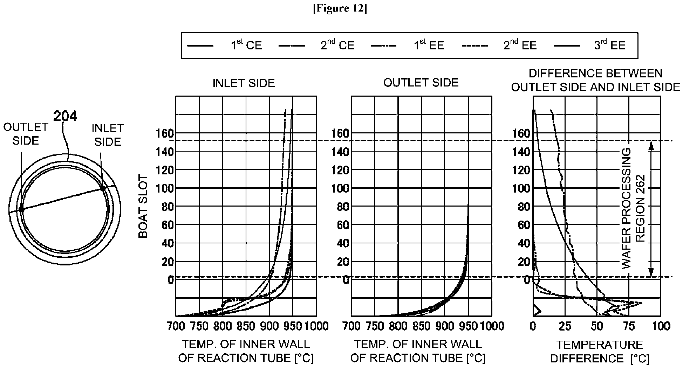

A graph on a left side of FIG. 12 schematically illustrates the temperatures (temperature distributions) of the inner walls of the reaction tubes according to the comparative examples and the examples at a side (indicated by "INLET SIDE") in the vertical direction where the gas introduction portion 233 is provided. A graph on a center side of FIG. 12 schematically illustrates the temperatures (temperature distributions) of the inner walls of the reaction tubes according to the comparative examples and the examples at a side (indicated by "OUTLET SIDE") in the vertical direction where the gas exhaust portion 231 is provided. The vertical axes of the graphs shown on the left side and the center side of FIG. 12 represent a height dimension (in unit of mm) with the lower end of the wafer processing region 262 as a reference ("0"), and the horizontal axes of the graphs shown on the left side and the center side of FIG. 12 represent the temperature (in unit of °C) of the inner wall of the reaction tube 204. The vertical axis of a graph on a right side of FIG. 12 represents the height dimension (in unit of mm) with the lower end of the wafer processing region 262 as the reference ("0"), and the horizontal axis of the graph on the right side of FIG. 12 represents the temperature difference between the temperature of the "INLET SIDE" and the temperature of the "OUTLET SIDE". As shown in the graph on the right side of FIG. 12, it is confirmed that the temperature difference in the wafer processing region 262 according to each of the examples is small as compared with that of each of the comparative examples. That is, the temperature unevenness (nonuniformity) in the wafer processing region 262 according to each of the examples is small as compared with that of each of the comparative examples. As described above, according to the configuration of each of the examples to which the embodiments of the technique is applied, it is possible to suppress the temperature unevenness (nonuniformity) in the wafer processing region 262 of the reaction tube 204. As a result, it is possible to uniformly process the plurality of wafers including the wafer 200 accommodated in the boat 217.

### <Another Embodiment>

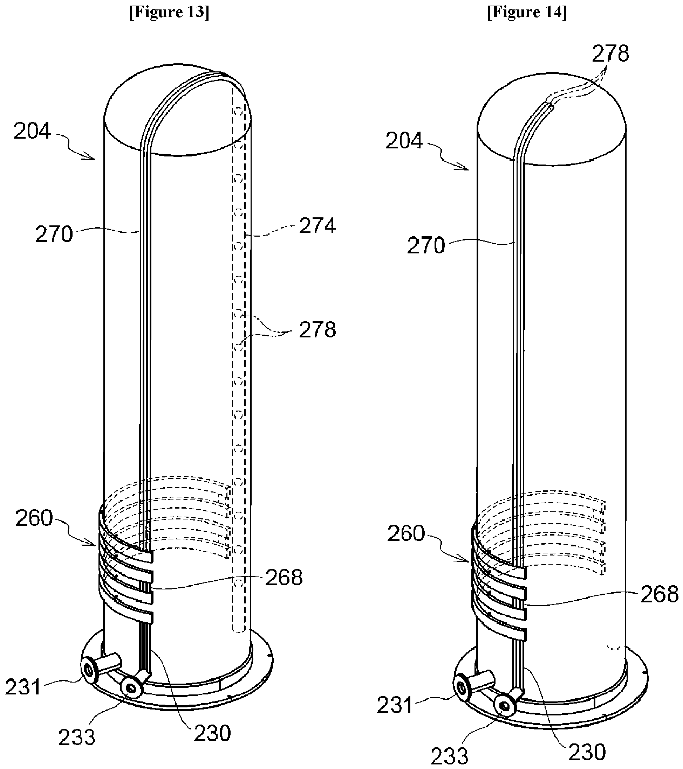

According to the embodiments described above, the buffer portion 272 is provided at the uppermost side of the reaction tube 204 in addition to the preheating portion 260, and the gas temporarily stagnated in the buffer portion 272 is heated. However, when the temperature of the gas ejected through the nozzle pipe 274 into the process chamber 201 is sufficiently high (that is, the temperature required for processing the wafer 200 is reached), as shown in FIG. 13, the buffer portion 272 may be omitted, and ends of the thin pipes 270 may be directly connected to the nozzle pipe 274. That is, according to another embodiment, the pipe member may include the thin pipes 230, the preheating portion 260, the thin pipes 270 and the nozzle pipe 274.

According to another embodiment described above, there is provided a substrate processing apparatus including: the reaction tube 204 provided therein with the process chamber 201 where the wafer 200 is processed; the gas introduction portion 233 provided at the lower end of the reaction tube 204 and through which the process gas is introduced into the reaction tube 204; the pipe member provided between the reaction tube 204 and the heater 206, extending in the direction from the gas introduction portion 233 to the nozzle pipe 274 across the ceiling of the reaction tube 204, and configured to communicate the gas introduction portion 233 with the nozzle pipe 274; and the gas exhaust portion 231 configure to exhaust the process gas from the process chamber 201. The nozzle pipe 274 is provided on the side surface of the reaction tube 204, and the gas holes 278 are provided at the nozzle pipe 274. The gas exhaust portion 231 is provided at the lower end of the reaction tube 204 opposite to the nozzle pipe 274. The pipe member includes the preheating path (that is, the preheating portion 260). The preheating portion 260 is provided on the side surface of the reaction tube 204 at the position lower than the substrate processing region where the plurality of the wafers including the wafer 200 are disposed in the process chamber 201, and extends in a direction intersecting with a direction of a shortest distance connecting the gas introduction portion 233 and the ceiling of the reaction tube 204. Operations and effects of another embodiment described above are the same as at least those of the first embodiment. According to another embodiment described above, at least one among the upper heater 280 and the ceiling heater 282 of the second embodiment may be further provided. In such a case, the operations and the effects of another embodiment described above are the same as those of the second embodiment.

### <Still Another Embodiment>

According to another embodiment described above, the temperature of the gas ejected through the nozzle pipe 274 into the process chamber 201 is sufficiently high (that is, the temperature required for processing the wafer 200 is reached). However, by providing the preheating portion 260, the temperature of the gas ejected into the process chamber 201 may be sufficiently increased and the temperature of the gas in the flow path up to the gas holes 278 may be sufficiently increased. Therefore, in such a case, as shown in FIG. 14, the buffer portion 272 and the nozzle pipe 274 may be omitted, and a simple configuration in which the thin pipes 230, the thin pipes 270 and the preheating portion 260 are provided on the outer peripheral surface of the reaction tube 204 and the gas holes 278 are provided at the thin pipes 270 at the ceiling of the reaction tube 204 may be used. That is, according to still another embodiment, the pipe member may include the thin pipes 230, the preheating portion 260 and the thin pipes 270.

According to still another embodiment described above, there is provided a substrate processing apparatus including: the reaction tube 204 provided therein with the process chamber 201 where the wafer 200 is processed; the gas introduction portion 233 provided at the lower end of the reaction tube 204 and through which the process gas is introduced into the reaction tube 204; the pipe member provided between the reaction tube 204 and the heater 206 and configured to communicate the gas introduction portion 233 with the gas holes 278; and the gas exhaust portion 231 configure to exhaust the process gas from the process chamber 201. The gas holes 278 are provided at the ceiling of the reaction tube 204, and are configured to supply the process gas into the process chamber 201. The pipe member includes the preheating path (that is, the preheating portion 260). The preheating portion 260 is provided on the side surface of the reaction tube 204 at the position lower than the substrate processing region where the plurality of the wafers including the wafer 200 are disposed in the process chamber 201, and extends in a direction intersecting with a direction of connecting the gas introduction portion 233 and the ceiling of the reaction tube 204 by the shortest distance. Operations and effects of still another embodiment described above are the same as those of the first embodiment.

According to still another embodiment described above, the buffer portion 272 provided at the ceiling of the reaction tube 204 to temporarily store the process gas may be further provided. The buffer portion 272 is configured to communicate the pipe member to the process chamber 201, and the gas holes 278 configured to supply the process gas into the process chamber 201 are provided at the buffer portion 272. In such a case, even when the process gas stagnates in the buffer portion 272 by providing the buffer portion 272, the process gas is heated by the heater 206. Therefore, it is possible to heat the process gas sufficiently. According to still another embodiment described above, at least one among the upper heater 280 and the ceiling heater 282 of the second embodiment may be further provided. In such a case, the operations and the effects of still another embodiment described above are the same as those of the second embodiment.

### <Other Embodiments>

While the technique is described in detail by way of the above-described embodiments, the above-described technique is not limited thereto. The above-described technique may be modified in various ways without departing from the gist thereof.

For example, the above-described embodiments are described by way of an example in which the flow path of the gas (that is, the preheating path constituted by components such as the preheating pipes 266 and the connecting pipes 268) is of the rectangular waveform shape when viewed from the reaction tube 204. However, the above-described technique is not limited thereto. For example, instead of the rectangular waveform shape, the preheating path may be of a so-called zigzag shape such as a sine curve shape and a triangular wave shape. In such a case, a specific shape of the zigzag shape and a direction in which the zigzag shape extends are not particularly limited.

That is, the preheating portion 260 may be constituted by: a first portion on the side surface of the reaction tube 204 extending in the direction (for example, the circumferential direction of the reaction tube 204) intersecting with the direction (for example, the vertical direction with respect to the reaction tube 204) of connecting the gas introduction portion 233 and the buffer portion 272 by the shortest distance in the flow path of the gas; and a second portion such as pipes bypassing in the circumferential direction rather than connecting the gas introduction portion 233 to the buffer portion 272 with the shortest distance so as to lengthen the preheating path. Thereby, it is possible to sufficiently preheat the gas.

Although not shown in the drawings, at the preheating portion 260, the preheating path (that is, the pipes) through which the gas passes may be provided in a spiral shape on the outer peripheral surface of the reaction tube 204. In such a case, it is possible to lengthen the preheating path through which the gas flows. Thereby, it is possible to sufficiently preheat the gas.

For example, the above-described embodiments are described by way of an example in which the wafer serving as a substrate is processed. However, the above-described technique is not limited thereto. For example, the above-described technique may also be applied to substrate processing apparatuses configured to process a glass substrate of a liquid crystal panel or a substrate such as a magnetic disk and an optical disk.

The invention may also be summarized as follows: Described herein is a technique capable of reducing a difference in processing results between substrates. According to one aspect of the technique, there is provided a reaction tube having a process chamber; a gas introduction portion provided at a lower end; a first supplier provided along a side surface to face a substrate processing region; and a preheating portion provided lower than the substrate processing region, the preheating portion including: a first preheating portion extending in a direction from the gas introduction portion toward a ceiling; and a second preheating portion extending in a direction perpendicular to the above direction, wherein the preheating portion connects the gas introduction portion with the first supplier by combining the first preheating portion and the second preheating portion.

### [Description of Reference Numerals]

| | |
|---|---|
| 100: substrate processing apparatus (processing apparatus) | 201: process chamber |
| 200: wafer (substrate) | 204: reaction tube (inner tube) |
| 202: process furnace | 217: boat (substrate retainer) |
| 206: heater (heating apparatus) | 231: gas exhaust portion (gas outlet) |
| 230:thin pipes (pipe member) | 240: controller (control device) |
| 233: gas introduction portion (gas inlet) | |
| 260:preheating portion (pipe member, preheating path) | |
| 262:wafer processing region (substrate processing region) | |
| 266:preheating pipes (second preheating portion, pipe member, preheating path) | |
| 268:connecting pipes (first preheating portion, pipe member, preheating path) | |
| 270:thin pipes (first supplier, pipe member) | |
| 274:nozzle pipe **(second supplier,** pipe member) | |
| 278: gas holes (gas supplier) | |
| 284: preheating pipes (**third preheating portion**, pipe member, preheating path) | |

## Claims

1. A reaction tube (204) provided therein with a process chamber (201) and heated by a heater provided therearound, the reaction tube (204) comprising:
a gas introduction portion (233) provided at a lower side and through which a process gas is introduced;
a first supplier (270) provided along a side surface at least at a position facing a substrate processing region (262) where a plurality of substrates (200) is processed; and
a preheating portion (260) provided at a position lower than the substrate processing region (262), the preheating portion (260) comprising:
a first preheating portion (268) extending in a direction from the gas introduction portion (233) toward a ceiling; and
a second preheating portion (266) extending in a direction perpendicular to the direction from the gas introduction portion (233) toward the ceiling,
wherein the preheating portion (260) is configured to connect the gas introduction portion (233) with the first supplier (270) by combining the first preheating portion (268) and the second preheating portion (266),
and wherein a cross-sectional shape of the first preheating portion (268) is different from that of the second preheating portion (266).

2. The reaction tube (204) of claim 1, wherein a preheating path is formed by combining the first preheating portion (268) and the second preheating portion (266) in an alternate manner.

3. The reaction tube (204) of claim 2, wherein a shape of the preheating path comprises at least one shape selected from the group consisting of a rectangular waveform, a sine waveform and a triangular waveform.

4. The reaction tube (204) of claim 2 and/or 3, wherein a starting point and an ending point of the preheating path are located at the second preheating portion (266).

5. The reaction tube (204) of any one or more of claims 1 to 4, wherein the first preheating portion (268) is provided between a position of the second preheating portion (266) and another position of the second preheating portion(266).

6. The reaction tube (204) of any one or more of claims 1 to 5, wherein a cross-sectional area of a flow path of the first preheating portion (268) is substantially same as that of a flow path of the second preheating portion (266).

7. The reaction tube (204) of any one or more of claims 1 to 5, wherein a cross-sectional area of a flow path of the second preheating portion (266) is greater than that of a flow path of the first preheating portion (268).

8. The reaction tube (204) of any one or more of claims 1 to 7, wherein the second preheating portion (266) comprises: a main preheating portion (284) configured to preheat the process gas; and a joint configured to connect the first preheating portion (268) and the main preheating portion (284),
wherein a cross-sectional shape of the first preheating portion (268) is different from that of the joint, and a cross-sectional shape of the first preheating portion (268) is same as that of the main preheating portion (284).

9. The reaction tube (204) of any one or more of claims 1 to 8, wherein the first preheating portion (268) comprises same configuration as that of the first supplier (270).

10. The reaction tube (204) of any one or more of claims 1 to 9, wherein each of the first preheating portion (268) and the first supplier (270) is constituted by a plurality of pipes, and
number of the pipes constituting the first preheating portion (268) is same as number of the pipes constituting the first supplier (270).

11. The reaction tube (204) of any one or more of claims 1 to 10, further comprising a plurality of mounting portions (266A), and
the second preheating portion (266) is provided at the side surface with the plurality of the mounting portions (266A) interposed therebetween.

12. The reaction tube (204) of any one or more of claims 1 to 11, further comprising a second supplier (274) provided at the side surface opposite to the gas introduction portion (233) wherein a gas supplier configured to supply the process gas into the process chamber (201) is provided at the second supplier (274),
wherein the second preheating portion (266) extends along a circumferential direction of the reaction tube (204) within an angular range determined according to a positional relationship between the gas introduction portion (233) and the second supplier (274).

13. The reaction tube (204) of claim 12, further comprising a gas exhaust portion (231) configure to exhaust the process gas from the process chamber (201),
wherein the second preheating portion (266) extends within a first angular range from an angular position of the gas introduction portion (233) to an angular position of the second supplier (274), the angular position of the gas exhaust portion (231) being included in the first angular range.

14. The reaction tube (204) of claim 12 and/or 13, wherein, when the angular position of the gas introduction portion (233) is defined as 0° and the angular position of the second supplier (274) is defined as N° (N is a positive number less than 360), the second preheating portion (266) extends within an angular range between 0° and N°.

15. The reaction tube (204) of claim 12 and/or 13, wherein, when the angular position of the gas introduction portion (233) is defined as 0° and the angular position of the second supplier (274) is defined as N° (N is a positive number less than 360), the second preheating portion (266) extends within an angular range between 180° and N°.

16. The reaction tube (204) of any one or more of claims 12 to 15, further comprising a temperature sensor (267) provided outside the reaction tube (204) and configured to detect a temperature of the process chamber (201),
wherein the temperature sensor (267) is located within a second angular range from an angular position of the gas introduction portion (233) to an angular position of the second supplier (274), the angular position of the gas exhaust portion (231) being excluded from the second angular range.

17. The reaction tube (204) of claim 16, wherein the second preheating portion (266) extends within an angular range from the angular position of the gas introduction portion (233) to the angular position of the temperature sensor (267) excluding the angular position of the gas exhaust portion (231).

18. A substrate processing apparatus (100) comprising:
a reaction tube (204) provided therein with a process chamber (201) and heated by a heater provided therearound;
a gas introduction portion (233) provided at a lower end of the reaction tube (204) and through which a process gas is introduced;
a first supplier (270) provided along a side surface of the reaction tube (204) at least at a position facing a substrate processing region (262) where a plurality of substrates (200) are processed; and
a preheating portion (260) provided at a position lower than the substrate processing region (262), the preheating portion (260) comprising:
a first preheating portion (268) extending in a direction from the gas introduction portion (233) toward a ceiling of the reaction tube (204); and
a second preheating portion (266) extending in a direction perpendicular to the direction from the gas introduction portion (233) toward the ceiling of the reaction tube (204),
wherein the preheating portion (260) is configured to connect the gas introduction portion (233) with the first supplier (270) by combining the first preheating portion (268) and the second preheating portion (266); and
a controller (240) configured to process the plurality of the substrates (200) by supplying the process gas onto the plurality of the substrates (200) via the preheating portion,
and wherein a cross-sectional shape of the first preheating portion (268) is different from that of the second preheating portion (266).

19. A method of manufacturing a semiconductor device comprising:
(a) loading a plurality of substrates (200) into a reaction tube (204) of a substrate processing apparatus (100), the substrate processing apparatus (100) comprising:
a reaction tube (204) provided therein with a process chamber (201) and heated by a heater provided therearound;
a gas introduction portion (233) provided at a lower end of the reaction tube (204) and through which a process gas is introduced;
a first supplier (270) provided along a side surface of the reaction tube (204) at least at a position facing a substrate processing region (262) where a plurality of substrates (200) are processed; and
a preheating portion (260) provided at a position lower than the substrate processing region (262), the preheating portion (260) comprising:
a first preheating portion (268) extending in a direction from the gas introduction portion (233) toward a ceiling of the reaction tube (204); and
a second preheating portion (266) extending in a direction perpendicular to the direction from the gas introduction portion (233) toward the ceiling of the reaction tube (204),
wherein the preheating portion (260) is configured to connect the gas introduction portion (233) with the first supplier (270) by combining the first preheating portion (268) and the second preheating portion (266),
wherein a cross-sectional shape of the first preheating portion (268) is different from that of the second preheating portion (266); and
(b) processing the plurality of the substrates (200) by supplying the process gas onto the plurality of the substrates (200) through the preheating portion (260).

## Patentansprüche

1. Eine Reaktionsröhre (204), die darin mit einer Verarbeitungskammer (201) versehen ist und von einer darum vorgesehenen Heizeinrichtung erhitzt wird, wobei die Reaktionsröhre (204) folgendes aufweist:
einen Gaseinführteil (233), der an einer unteren Seite vorgesehen ist, und durch welchen ein Verarbeitungsgas eingeführt wird;
eine erste Zufuhreinrichtung (270), die entlang einer Seitenoberfläche vorgesehen ist, und zwar wenigstens an einer Position, die einem Substratverarbeitungsbereich (262) zugewandt ist, wo eine Vielzahl von Substraten (200) verarbeitet wird; und
einen Vorheizteil (260), der an einer niedrigeren Position als der Substratverarbeitungsbereichs (262) vorgesehen ist, wobei der Vorheizteil (260) folgendes aufweist:
einen ersten Vorheizteil (268), der sich in einer Richtung von dem Gaseinführteil (233) zu einer Decke hin erstreckt, und
einen zweiten Vorheizteil (266), der sich in einer Richtung senkrecht zu der Richtung von dem Gaseinführteil (233) zu der Decke hin erstreckt,
wobei der Vorheizteil (260) konfiguriert ist, um den Gaseinführteil (233) mit der ersten Zufuhreinrichtung (270) zu verbinden, und zwar durch Kombinieren des ersten Vorheizteils (268) und des zweiten Vorheizteils (266),
und wobei eine Querschnittsform des ersten Vorheizteils (268) verschieden zu derjenigen des zweiten Vorheizteils (266) ist.

2. Die Reaktionsröhre (204) nach Anspruch 1, wobei ein Vorheizpfad durch Kombinieren des ersten Vorheizteils (268) und des zweiten Vorheizteils (266) in einer abwechselnden Weise gebildet wird.

3. Die Reaktionsröhre (204) nach Anspruch 2, wobei eine Form des Vorheizpfads wenigstens eine Form aufweist, die aus der Gruppe ausgewählt ist, die aus einer Rechteckswellenform, einer Sinuswellenform und einer Dreieckswellenform besteht.

4. Die Reaktionsröhre (204) nach Anspruch 2 und/oder 3, wobei ein Startpunkt und ein Endpunkt des Vorheizpfads an dem zweiten Vorheizteil (266) angeordnet sind.

5. Die Reaktionsröhre (204) nach einem oder mehreren der Ansprüche 1 bis 4, wobei der erste Vorheizteil (268) zwischen einer Position des zweiten Vorheizteils (266) und einer weiteren Position des zweiten Vorheizteils (266) vorgesehen ist.

6. Die Reaktionsröhre (204) nach einem oder mehreren der Ansprüche 1 bis 5, wobei eine Querschnittsfläche eines Strömungspfads des ersten Vorheizteils (268) im Wesentlichen dieselbe wie diejenige eines Strömungspfads des zweiten Vorheizteils (266) ist.

7. Die Reaktionsröhre (204) nach einem oder mehreren der Ansprüche 1 bis 5, wobei eine Querschnittsfläche eines Strömungspfads des zweiten Vorheizteils (266) größer als diejenige eines Strömungspfads des ersten Vorheizteils (268) ist.

8. Die Reaktionsröhre (204) nach einem oder mehreren der Ansprüche 1 bis 7, wobei der zweite Vorheizteil (266) folgendes aufweist: einen Hauptvorheizteil (284), der konfiguriert ist, um das Verarbeitungsgas vorzuheizen; und eine Verbindung, die konfiguriert ist, um das erste Vorheizteil (268) und das Hauptvorheizteil (284) zu verbinden,
wobei eine Querschnittsform des ersten Vorheizteils (268) verschieden zu derjenigen der Verbindung ist, und eine Querschnittsform von dem ersten Vorheizteil (268) dieselbe wie diejenige des Hauptvorheizteils (284) ist.

9. Die Reaktionsröhre (204) nach einem oder mehreren der Ansprüche 1 bis 8, wobei der erste Vorheizteil (268) dieselbe Konfiguration wie diejenige der ersten Zufuhreinrichtung (270) aufweist.

10. Die Reaktionsröhre (204) nach einem oder mehreren der Ansprüche 1 bis 9, wobei jedes von dem ersten Vorheizteil (268) und der ersten Zufuhreinrichtung (270) aus einer Vielzahl von Rohren gebildet ist, und
eine Anzahl der Rohre, welche den ersten Vorheizteil (268) bilden, ist dieselbe wie die Anzahl der Rohre, welche die erste Zufuhreinrichtung (270) bilden.

11. Die Reaktionsröhre (204) nach einem oder mehreren der Ansprüche 1 bis 10, die ferner eine Vielzahl von Befestigungsteilen (266A) aufweist, und
der zweite Vorheizteil (266) an der Seitenoberfläche mit der Vielzahl von dazwischen eingefügten Befestigungsteilen (266A) vorgesehen ist.

12. Die Reaktionsröhre (204) nach einem oder mehreren der Ansprüche 1 bis 11, die ferner eine zweite Zufuhreinrichtung (274) aufweist, die an der Seitenoberfläche gegenüber zu dem Gaseinführteil (233) vorgesehen ist, wobei eine Gaszufuhreinrichtung, die konfiguriert ist, um das Verarbeitungsgas in die Verarbeitungskammer (201) zuzuführen, an der zweiten Zufuhreinrichtung (274) vorgesehen ist,
wobei der zweite Vorheizteil (266) sich entlang einer Umfangsrichtung der Reaktionsröhre (204) innerhalb eines Winkelbereichs erstreckt, der gemäß einer Positionsbeziehung zwischen dem Gaseinführteil (233) und der zweiten Zufuhreinrichtung (274) bestimmt ist.

13. Die Reaktionsröhre (204) nach Anspruch 12, die ferner einen Gasauslassteil (231) aufweist, der konfiguriert ist, um das Verarbeitungsgas von der Verarbeitungskammer (201) auszulassen,
wobei der zweite Vorheizteil (266) sich innerhalb eines ersten Winkelbereichs von einer Winkelposition des Gaseinführteils (233) zu einer Winkelposition der zweiten Zufuhreinrichtung (274) erstreckt, wobei die Winkelposition des Gasauslassteils (231) in dem ersten Winkelbereich enthalten ist.

14. Die Reaktionsröhre (204) nach Anspruch 12 und/oder 13, wobei, wenn die Winkelposition des Gaseinführteils (233) als 0° definiert ist und die Winkelposition der zweiten Zufuhreinrichtung (274) als N° definiert ist (N ist eine positive Zahl kleiner als 360), der zweite Vorheizteil (266) sich innerhalb eines Winkelbereichs zwischen 0° und N° erstreckt.

15. Die Reaktionsröhre (204) nach Anspruch 12 und/oder 13, wobei, wenn die Winkelposition des Gaseinführteils (233) als 0° definiert ist und die Winkelposition der zweiten Zufuhreinrichtung (274) als N° definiert ist (N ist eine positive Zahl kleiner als 360), der zweite Vorheizteil (266) sich innerhalb eines Winkelbereichs zwischen 180° und N° erstreckt.

16. Die Reaktionsröhre (204) nach einem oder mehreren der Ansprüche 12 bis 15, die ferner einen Temperatursensor (267), der außerhalb der Reaktionsröhre (204) vorgesehen ist und konfiguriert ist, um eine Temperatur der Verarbeitungskammer (201) zu detektieren,
wobei der Temperatursensor (267) innerhalb eines zweiten Winkelbereichs von einer Winkelposition des Gaseinführteils (233) zu einer Winkelposition der zweiten Zufuhreinrichtung (274) angeordnet ist, wobei die Winkelposition des Gasauslassteils (231) von dem zweiten Winkelbereich ausgeschlossen ist.

17. Die Reaktionsröhre (204) nach Anspruch 16, wobei der zweite Vorheizteil (266) sich innerhalb eines Winkelbereichs von der Winkelposition des Gaseinführteils (233) bis zu der Winkelposition des Temperatursensors (267) erstreckt, und zwar ausschließlich der Winkelposition des Gasauslassteils (231).

18. Eine Substratverarbeitungsvorrichtung (100), die folgendes aufweist:
eine Reaktionsröhre (204), die darin mit einer Verarbeitungskammer (201) versehen ist und von einer darum vorgesehenen Heizeinrichtung erhitzt wird;
einen Gaseinführteil (233), der an einem unteren Ende der Reaktionsröhre (204) vorgesehen ist, und durch welchen ein Verarbeitungsgas eingeführt wird;
eine erste Zufuhreinrichtung (270), die entlang einer Seitenoberfläche der Reaktionsröhre (204) vorgesehen ist, und zwar wenigstens an einer Position, die einem Substratverarbeitungsbereich (262) zugewandt ist, wo eine Vielzahl von Substraten verarbeitet werden; und
ein Vorheizteil (260), der an einer niedrigeren Position als der Substratverarbeitungsbereich (262) vorgesehen ist, wobei der Vorheizteil (260) folgendes aufweist:
einen ersten Vorheizteil (268), der sich in einer Richtung von dem Gaseinführteil (233) zu einer Decke der Reaktionsröhre (204) hin erstreckt; und
einen zweiten Vorheizteil (266), der sich in einer Richtung senkrecht zu der Richtung von dem Gaseinführteil (233) zu der Decke der Reaktionsröhre (204) hin erstreckt,
wobei der Vorheizteil (260) konfiguriert ist, um den Gaseinführteil (233) mit der ersten Zufuhreinrichtung (270) zu verbinden, und zwar durch Kombinieren des ersten Vorheizteils (268) und des zweiten Vorheizteils (266); und
eine Steuereinrichtung (240), die konfiguriert ist, um die Vielzahl der Substrate (200) durch Zuführung des Verarbeitungsgases auf die Vielzahl der Substrate (200) über den Vorheizteil zu verarbeiten,
und wobei eine Querschnittsform des ersten Vorheizteils (268) verschieden zu derjenigen des zweiten Vorheizteils (266) ist.

19. Ein Verfahren zur Herstellung einer Halbleitereinrichtung, das folgendes aufweist:
(a) Laden einer Vielzahl von Substrates (200) in eine Reaktionsröhre (204) einer Substratverarbeitungsvorrichtung (100), wobei die Substratverarbeitungsvorrichtung (100) folgendes aufweist:
eine Reaktionsröhre (204), die darin mit einer Verarbeitungskammer (201) versehen ist, und von einer darum vorgesehenen Heizeinrichtung erhitzt wird;
einen Gaseinführteil (233), der an einem unteren Ende der Reaktionsröhre (204) vorgesehen ist, und durch welchen ein Verarbeitungsgas eingeführt wird;
eine erste Zufuhreinrichtung (270), die entlang einer Seitenoberfläche der Reaktionsröhre (204) vorgesehen ist, und zwar wenigstens an einer Position, die einem Substratverarbeitungsbereich (262) zugewandt ist, wo eine Vielzahl von Substraten (200) verarbeitet werden; und
ein Vorheizteil (260), der an einer niedrigeren Position als der Substratverarbeitungsbereich (262) vorgesehen ist, wobei der Vorheizteil (260) folgendes aufweist:
einen ersten Vorheizteil (268), der sich in einer Richtung von dem Gaseinführteil (233) zu einer Decke der Reaktionsröhre (204) hin erstreckt; und
einen zweiten Vorheizteil (266), der sich in einer Richtung senkrecht zu der Richtung von dem Gaseinführteil (233) zu der Decke der Reaktionsröhre (204) hin erstreckt,
wobei der Vorheizteil (260) konfiguriert ist, um den Gaseinführteil (233) mit der ersten Zufuhreinrichtung (270) zu verbinden, und zwar durch Kombinieren des ersten Vorheizteils (268) und des zweiten Vorheizteils (266),
wobei eine Querschnittsform des ersten Vorheizteils (268) verschieden zu derjenigen des zweiten Vorheizteils (266) ist; und
(b) Verarbeiten der Vielzahl von Substraten (200) durch Zuführen des Verarbeitungsgases auf die Vielzahl der Substrate (200) durch den Vorheizteil (260).

## Revendications

1. Tube de réaction (204) prévu à l'intérieur d'une chambre de traitement (201) et chauffé par un élément chauffant disposé autour de celui-ci, le tube de réaction (204) comprenant :
une partie d'introduction de gaz (233) disposée sur un côté inférieur et à travers laquelle un gaz de traitement est introduit ;
un premier dispositif d'alimentation (270) disposé le long d'une surface latérale au moins à une position faisant face à une région de traitement de substrats (262) où une pluralité de substrats (200) est traitée ; et
une partie de préchauffage (260) disposée à une position plus basse que la région de traitement de substrats (262), la partie de préchauffage (260) comprenant :
une première partie de préchauffage (268) s'étendant dans une direction allant de la partie d'introduction de gaz (233) vers un plafond ; et
une deuxième partie de préchauffage (266) s'étendant dans une direction perpendiculaire à la direction allant de la partie d'introduction de gaz (233) vers le plafond,
dans lequel la partie de préchauffage (260) est configurée pour relier la partie d'introduction de gaz (233) au premier dispositif d'alimentation (270) en combinant la première partie de préchauffage (268) et la deuxième partie de préchauffage (266),
et dans lequel une forme en coupe transversale de la première partie de préchauffage (268) est différente de celle de la deuxième partie de préchauffage (266).

2. Tube de réaction (204) selon la revendication 1, dans lequel un trajet de préchauffage est formé en combinant la première partie de préchauffage (268) et la deuxième partie de préchauffage (266) d'une manière alternée.

3. Tube de réaction (204) selon la revendication 2, dans lequel une forme du trajet de préchauffage comprend au moins une forme sélectionnée parmi le groupe constitué d'une forme d'onde rectangulaire, d'une forme d'onde sinusoïdale et d'une forme d'onde triangulaire.

4. Tube de réaction (204) selon la revendication 2 et/ou 3, dans lequel un point de départ et un point d'arrivée du trajet de préchauffage sont situés au niveau de la deuxième partie de préchauffage (266).

5. Tube de réaction (204) selon l'une ou plusieurs des revendications 1 à 4, dans lequel la première partie de préchauffage (268) est disposée entre une position de la deuxième partie de préchauffage (266) et une autre position de la deuxième partie de préchauffage (266).

6. Tube de réaction (204) selon l'une ou plusieurs des revendications 1 à 5, dans lequel une surface en coupe transversale d'un trajet d'écoulement de la première partie de préchauffage (268) est sensiblement la même que celle d'un trajet d'écoulement de la deuxième partie de préchauffage (266).

7. Tube de réaction (204) selon l'une ou plusieurs des revendications 1 à 5, dans lequel une surface en coupe transversale d'un trajet d'écoulement de la deuxième partie de préchauffage (266) est supérieure à celle d'un trajet d'écoulement de la première partie de préchauffage (268).

8. Tube de réaction (204) selon l'une ou plusieurs des revendications 1 à 7, dans lequel la deuxième partie de préchauffage (266) comprend : une partie de préchauffage principale (284) configurée pour préchauffer le gaz de traitement ; et un joint configuré pour relier la première partie de préchauffage (268) et la partie de préchauffage principale (284),
dans lequel une forme en coupe transversale de la première partie de préchauffage (268) est différente de celle du joint, et une forme en coupe transversale de la première partie de préchauffage (268) est identique à celle de la partie de préchauffage principale (284).

9. Tube de réaction (204) selon l'une ou plusieurs des revendications 1 à 8, dans lequel la première partie de préchauffage (268) comprend une même configuration que celle du premier dispositif d'alimentation (270).

10. Tube de réaction (204) selon l'une ou plusieurs des revendications 1 à 9, dans lequel chacun de la première partie de préchauffage (268) et du premier dispositif d'alimentation (270) est constitué d'une pluralité de tuyaux, et
le nombre de tuyaux constituant la première partie de préchauffage (268) est le même que le nombre de tuyaux constituant le premier dispositif d'alimentation (270) .

11. Tube de réaction (204) selon l'une ou plusieurs des revendications 1 à 10, comprenant en outre une pluralité de parties de montage (266A), et
la deuxième partie de préchauffage (266) est disposée au niveau de la surface latérale avec la pluralité des parties de montage (266A) interposées entre elles.

12. Tube de réaction (204) selon l'une ou plusieurs des revendications 1 à 11, comprenant en outre un deuxième dispositif d'alimentation (274) disposé au niveau de la surface latérale opposée à la partie d'introduction de gaz (233), dans lequel un dispositif d'alimentation en gaz configuré pour alimenter en gaz de traitement la chambre de traitement (201) est disposé au niveau du deuxième dispositif d'alimentation (274),
dans lequel la deuxième partie de préchauffage (266) s'étend le long d'une direction circonférentielle du tube de réaction (204) dans une plage angulaire déterminée selon une relation de position entre la partie d'introduction de gaz (233) et le deuxième dispositif d'alimentation (274).

13. Tube de réaction (204) selon la revendication 12, comprenant en outre une partie d'échappement de gaz (231) configurée pour évacuer le gaz de traitement depuis la chambre de traitement (201),
dans lequel la deuxième partie de préchauffage (266) s'étend dans une première plage angulaire allant d'une position angulaire de la partie d'introduction de gaz (233) à une position angulaire du deuxième dispositif d'alimentation (274), la position angulaire de la partie d'échappement de gaz (231) étant comprise dans la première plage angulaire.

14. Tube de réaction (204) selon la revendication 12 et/ou 13, dans lequel, lorsque la position angulaire de la partie d'introduction de gaz (233) est définie comme étant 0° et la position angulaire du deuxième dispositif d'alimentation (274) est définie comme étant N° (N est un nombre positif inférieur à 360), la deuxième partie de préchauffage (266) s'étend dans une plage angulaire comprise entre 0° et N°.

15. Tube de réaction (204) selon la revendication 12 et/ou 13, dans lequel, lorsque la position angulaire de la partie d'introduction de gaz (233) est définie comme étant 0° et la position angulaire du deuxième dispositif d'alimentation (274) est définie comme étant N° (N est un nombre positif inférieur à 360), la deuxième partie de préchauffage (266) s'étend dans une plage angulaire comprise entre 180° et N°.

16. Tube de réaction (204) selon l'une ou plusieurs des revendications 12 à 15, comprenant en outre un capteur de température (267) disposé à l'extérieur du tube de réaction (204) et configuré pour détecter une température de la chambre de traitement (201),
dans lequel le capteur de température (267) est situé dans une deuxième plage angulaire allant d'une position angulaire de la partie d'introduction de gaz (233) à une position angulaire du deuxième dispositif d'alimentation (274), la position angulaire de la partie d'échappement de gaz (231) étant exclue de la deuxième plage angulaire.

17. Tube de réaction (204) selon la revendication 16, dans lequel la deuxième partie de préchauffage (266) s'étend dans une plage angulaire allant de la position angulaire de la partie d'introduction de gaz (233) à la position angulaire du capteur de température (267) excluant la position angulaire de la partie d'échappement de gaz (231).

18. Appareil de traitement de substrats (100) comprenant :
un tube de réaction (204) prévu à l'intérieur d'une chambre de traitement (201) et chauffé par un élément chauffant disposé autour de celui-ci ;
une partie d'introduction de gaz (233) disposée sur une extrémité inférieure du tube de réaction (204) et à travers laquelle un gaz de traitement est introduit ;
un premier dispositif d'alimentation (270) disposé le long d'une surface latérale du tube de réaction (204) au moins à une position faisant face à une région de traitement de substrats (262) où une pluralité de substrats (200) est traitée ; et
une partie de préchauffage (260) disposée à une position plus basse que la région de traitement de substrats (262), la partie de préchauffage (260) comprenant :
une première partie de préchauffage (268) s'étendant dans une direction allant de la partie d'introduction de gaz (233) vers un plafond du tube de réaction (204) ; et
une deuxième partie de préchauffage (266) s'étendant dans une direction perpendiculaire à la direction allant de la partie d'introduction de gaz (233) vers le plafond du tube de réaction (204), dans lequel la partie de préchauffage (260) est configurée pour relier la partie d'introduction de gaz (233) au premier dispositif d'alimentation (270) en combinant la première partie de préchauffage (268) et la deuxième partie de préchauffage (266) ; et
un dispositif de commande (240) configuré pour traiter la pluralité des substrats (200) en alimentant le gaz de traitement sur la pluralité des substrats (200) via la partie de préchauffage,
et dans lequel une forme en coupe transversale de la première partie de préchauffage (268) est différente de celle de la deuxième partie de préchauffage (266).

19. Procédé de fabrication d'un dispositif à semiconducteur comprenant :
(a) le chargement d'une pluralité de substrats (200) dans un tube de réaction (204) d'un appareil de traitement de substrats (100), l'appareil de traitement de substrats (100) comprenant :
un tube de réaction (204) prévu à l'intérieur d'une chambre de traitement (201) et chauffé par un élément chauffant disposé autour de celui-ci ;
une partie d'introduction de gaz (233) disposée sur une extrémité inférieure du tube de réaction (204) et à travers laquelle un gaz de traitement est introduit ;
un premier dispositif d'alimentation (270) disposé le long d'une surface latérale du tube de réaction (204) au moins à une position faisant face à une région de traitement de substrats (262) où une pluralité de substrats (200) est traitée ; et
une partie de préchauffage (260) disposée à une position plus basse que la région de traitement de substrats (262), la partie de préchauffage (260) comprenant :
une première partie de préchauffage (268) s'étendant dans une direction allant de la partie d'introduction de gaz (233) vers un plafond du tube de réaction (204) ; et
une deuxième partie de préchauffage (266) s'étendant dans une direction perpendiculaire à la direction allant de la partie d'introduction de gaz (233) vers le plafond du tube de réaction (204),
dans lequel la partie de préchauffage (260) est configurée pour relier la partie d'introduction de gaz (233) au premier dispositif d'alimentation (270) en combinant la première partie de préchauffage (268) et la deuxième partie de préchauffage (266),
dans lequel une forme en coupe transversale de la première partie de préchauffage (268) est différente de celle de la deuxième partie de préchauffage (266) ; et
(b) le traitement de la pluralité des substrats (200) en alimentant le gaz de traitement sur la pluralité des substrats (200) à travers la partie de préchauffage (260).
